(19) Europäisches Patentamt
European Patent Office
Office européen des brevets

(11) EP 1 760 761 B1

(12) EUROPEAN PATENT SPECIFICATION

(45) Date of publication and mention
of the grant of the patent:
**18.10.2017 Bulletin 2017/42**

(51) Int Cl.:
*H01J 37/073* (2006.01)     *H01J 37/04* (2006.01)
*H01J 37/30* (2006.01)     *H01J 37/06* (2006.01)
*H01J 3/02* (2006.01)     *H01J 1/30* (2006.01)

(21) Application number: **05019259.0**

(22) Date of filing: **05.09.2005**

(54) **Charged particle beam emitting device and method for operating a charged particle beam emitting device**

Ladungsträgerstrahl-Emittiervorrichtung und Verfahren zum Betrieb einer Ladungsträgerstrahl-Emittiervorrichtung

Emetteur de faisceau à particules chargées et procédé de fonctionnement d'un émetteur de faisceau à particules chargées

(84) Designated Contracting States:
**DE GB NL**

(43) Date of publication of application:
**07.03.2007 Bulletin 2007/10**

(60) Divisional application:
**08159925.0 / 1 993 119**

(73) Proprietor: **ICT Integrated Circuit Testing Gesellschaft für Halbleiterprüftechnik mbH 85551 Heimstetten (DE)**

(72) Inventors:
• **Zhou, Fang**
  **85652 Pliening (DE)**
• **Adamec, Pavel**
  **85540 Haar (DE)**
• **Frosien, Jürgen**
  **85521 Riemerling (DE)**

• **Vishnipolsky, Jimmy**
  **Petah Tikwa (IL)**

(74) Representative: **Zimmermann & Partner Patentanwälte mbB Postfach 330 920 80069 München (DE)**

(56) References cited:
  **US-A- 3 786 268     US-A- 3 825 839**
  **US-A- 3 887 839     US-A- 4 090 106**
  **US-A- 5 399 865     US-A1- 2004 124 365**

• **W.K. LO, G.PARTHASARATHY, C.W. LO, D.M. TANENBAUM, H.G. CRAIGHEAD, M.S.ISAACSON: "TITANIUM NITRIDE COATED TUNGSTEN COLD FIELD EMISSION SOURCES" J. VAC. SCI TECHNOL. B, vol. 14, no. 6, 1996, pages 3787-3791, XP002372279**

**Description**

BACKGROUND OF THE INVENTION

The invention relates to improvements in the field of charged particle beam apparatuses emitting a charged particle beam and, more particularly, pertains to a method for operating an electron beam emitting device including a cold field emitter.

Charged particle beam emitters such as cold field emission emitters have an enormous potential due to their high brightness, small source size and low energy spread. A cold field emitter typically includes a crystal of tungsten formed to a very narrow point which is mounted to a loop of a tungsten wire. The very narrow point is also frequently referred to as emitter tip. When applying a voltage to the cold field emitter, a very high electric field is formed at the emitter tip due to its small curvature. The high electric field enables the electrons to pass the potential barrier between the metal and the vacuum in which the cold field emitter is placed. Accordingly, the established electric field is often referred to as electric extractor field as it causes the electrons to be "extracted" from the emitter tip. As compared to so-called thermal emitters, which are heated to a temperature sufficient to enable thermal emission, cold field emitters are not heated so that electrons are only emitted due to the presence of the strong electric field. As the electric field strength of the electric extractor field is only sufficiently strong in the vicinity of the highly curved emitter tip, electrons are only emitted there from resulting in a point-like electron source.

Despites its superior advantages with respect to brightness, source size and low energy spread, cold field emitters are also known as being unstable and delicate due to adsorption and desorption of residual gas molecules of the vacuum which drastically alters the emission characteristic of the cold field emitter. In order to obtain a reasonably stable emission, an ultra high vacuum is required which is typically better than $1.33 * 10^{-7}$ Pa ($10^{-9}$ Torr) and in particular better than $1.33 * 10^{-9}$ Pa ($10^{-11}$ Torr). Principally, the lower the pressure the better the vacuum and hence the stability.

A typical emission characteristic of a clean cold field emitter under a constant extraction field exhibits an initial high emission current $I_0$. Upon further operation under standard conditions (i.e. under a constant electric extraction field, a given vacuum and a constant low temperature) the emission current declines continuously due to increasing adsorption of residual gas molecules in the vacuum on the surface of the emitter tip. At the same time, gas molecules adhering to the emitter surface begin to desorb from the emitter surface so that after a certain period of time adsorption and desorption of gas molecules are balanced. When the balance condition is reached, in other word, when a dynamical equilibrium of adsorption and desorption has been established, the emission current is substantially stable and assumes a stable mean emission current $I_S$. Under this balanced condition the emission current fluctuates around the substantially stable mean emission current $I_S$ which is well below than the initial high emission current $I_0$. An exemplary emission current of a cold field emitter is for instance shown Figure 1 of Okumura et al. (US 4,090,106) which is reproduced in Figure 4 of the present application. As indicated in Figure 4, the emission current I declines from $I_0$ to a stable mean emission current $I_1$ (= Is). This period is sometimes referred to as the initial unstable period. The time required for the stabilisation of the emission current and the extent of the emission current decline depend on the quality of the vacuum. The balanced condition is established after a few minutes depending on the quality of the vacuum. Conventionally, the period of stable emission is sometimes referred to as stable emission period.

In order to obtain a constant emission current Okumura et al. suggest controlling the field strength of the extraction field so that the emission current is kept about $I_S$ even during the initial unstable region. Specifically, at the beginning of the field emission when the emitter tip is still clean, a lower electric extraction field is applied to keep the emission current at $I_S$. Upon further operation, the field strength of the electric extraction field is ramped up to compensate the decline of the emission current which would otherwise occur under constant electric field conditions.

The balanced conditions may be affected by positively charged ions or molecules, which are accelerated by the electric extraction field towards the surface of the emitter tip resulting in fluctuations of the emission current. Molecules or ions impinging on the surface of the emitter tip lead to a partial desorption of adsorbed gas molecules and hence to a temporal removal of residual gas molecules from the emitter tip resulting in a temporal rise of the emission current. As this effect is counterbalanced by a continuous adsorption of gas molecules, a fluctuation of the emission current is observed. The fluctuations become stronger over long periods of operation and, using the notation of Okumura et al., a terminal unstable region is reached when strong fluctuations are observable. In the worst case, the fluctuations may result in an avalanche of desorption and a subsequent uncontrolled emission. The emitter tip may be destroyed if the field strength of the electric extraction field cannot be reduced fast enough.

To reduce fluctuations and to increase the emission current, different approaches have been suggested. For example, the emitter tip can be coated with a material having a low work function to reduce the voltage required for extracting electrons. Alternatively, the emitter tip such as ZrO/W[100] Shottky emitter can be heated to about 1800 K to 2000 K to thermally stimulate electron emission. However, such emitters are not "cold" emitters. Contrary to cold emitters, hot or thermal emitters emit from the whole emitter surface and not only from the emitter tip and therefore do not have a point-like source as cold emitters. A further option for reducing fluctuations is to improve the vacuum. However, this approach is very expensive and increases the cost-of-ownership.

It has also been proposed to decontaminate the emitter tip after a given long period of operation. Typically, the emitter tip is cleaned by short heating pulses, also referred to as flashing, during which the emitter tip is heated to a temperature sufficiently high to cause a noticeable desorption of adsorbed gas molecules. As for instance disclosed by Okumura et al. referred to above, the emitter tip is decontaminated by flashing using an electrical heater when the fluctuations about the mean stable emission current $I_S$ becomes more pronounced. The decontamination intervals are then typically in the range of hours. It is also known to heat the emitter tip of a cathode-ray type electron gun at fixed time intervals as for instance described by Iwasaki (US 5,491,375) to keep the emission stable at the mean emission current $I_S$. Furthermore, Steigerwald (US 2004/0124365) suggests using a photon beam focussed on the emitter tip to heat the emitter tip to a temperature of about 1300 K to 1500 K for a partial decontamination.

The application of heating pulses for cleaning the filament of an electron gun device is described in US-A-3 786 268. The heating pulses are applied when the electron gun is operated in the stable emission period, i.e. the emission current is $I_S$. This shall avoid drifting of the electron gun device into the terminal unstable region in which avalanche desorption and the uncontrolled increase of the emission current occur.

The electron beam device of US-A-3 825 839 comprises a detecting means for detecting the emission current fluctuation and a control means for controlling the electrical field for field emission according to the output signal of the detecting means. Hence, the emission current is controlled by varying the applied electrical field.

A pulsed field emission type electron gun is described in US-A-3 887 839. This electron gun comprises a heated emitter to which voltage pulses of constant amplitude are applied. To control the emission characteristic of the emitter, the pulse duty is changed.

SUMMARY OF THE INVENTION

In view of the above, a method for operating a charged particle beam emitting device including a charged particle beam source having an emitter surface is provided, the method includes the steps of:

(a) placing the charged particle beam source in a vacuum of a given pressure, the charged particle beam source exhibiting a high initial emission current $I_0$ and a lower stable mean emission current $I_S$ under given operational conditions,

(b) applying the given operational conditions to the charged particle beam source for emitting charged particles from the emitter surface, so that the emission current of the charged particle beam source is higher than the stable mean emission current Is,

(c) performing a cleaning process by applying at least one heating pulse to the charged particle beam source for heating the emitter surface to a temperature $T_C$, whereby the cleaning process is performed before the emission current of the charged particle beam source has declined to the lower stable mean emission value Is, and

(d) repeating the cleaning process (c) to keep the emission current of the charged particle beam source continuously above the substantially stable emission value $I_S$.

In the following description, the term "particles" and "charged particle" are used synonymously throughout the description and refer to any type of charged particles. Further, the term "a particle beam source" and "a charged particle beam source" are also used synonymously throughout the description. Examples of charged particles are electrons and ions. According to an aspect of the above method, the particle beam emitting device is an electron beam emitting device, the particle beam source is an electron emitter for emitting electrons and the given operational conditions includes a given pressure and a given energy applied to the emitter surface of the electron emitter. Examples of electron emitters are photo-emitters, field assisted photo-emitters and cold field emitters. For photo-emitters and field assisted photo-emitters, the energy is at least partially applied as radiation of a given wavelength being sufficient to stimulate photo-emission. On the contrary, cold field emitters emit electrons due to a strong electric extraction field applied to the emitter surface.

The frequent cleaning is in particular suitable for emitters which do not require a supply of heat in order to emit particles. Therefore, when referring to charged particle beam sources so called "cold" emitters are in particular meant such as cold field emitters, photo-emitters and cold ion emitters. Hence, according to an aspect, charged particle beam sources are "cold" emitters but not "thermal" emitters, the latter are heated to provide sufficient energy for emitting particles.

In case of an electron beam emitting device, the above method is provided for operating an electron beam emitting device, whereby the electron beam emitting device includes a cold field emitter having an emitter surface, the method includes the steps of:

(a) placing the cold field emitter in a vacuum of a given pressure, the cold field emitter exhibiting a high initial emission current $I_0$ and a lower stable mean emission current $I_S$ under a given electric extraction field,

(b) applying the given electric extraction field to the cold field emitter for emitting electrons from the emitter surface, so that the emission current of the cold field emitter is higher than the stable mean emission current $I_S$,

(c) performing a cleaning process by applying at least one heating pulse to the cold field emitter for heating the emitter surface to a temperature $T_C$, whereby the cleaning process is performed before the emission current of the cold field emitter is declined to the lower stable mean emission value $I_S$, and

(d) repeating the cleaning process (c) to keep the emission current of the cold field emitter continuously above the substantially stable emission value $I_S$.

Further advantages, features, aspects and details of the invention are evident from the claims, the description and the accompanying drawings. Although the invention is mainly description in conjunction with an electron beam emitting device, the invention is not restricted thereto but can generally be applied to particle beam emitting devices such as ion beam emitting devices. Those skilled in the art will appreciate that the method as set fort below is suitable for any kind of charged particle beam emitting devices to keep the emitter surface continuously free or substantially free from debris and contamination to obtain very high emitting currents and to extend the life time of the particle emitter.

By frequently performing a cleaning process the emission from the emitter surface can be maintained at very high level above the stable mean emission current at which cold field electron emitters are typically operated. With reference to the general emission characteristic of a cold field emitter, the cold field emitter is operated by the present method such that its emission remains in the initial unstable region. In that region, fluctuations are less pronounced than in the stable region since the amount of adsorbed gas molecules is continuously kept to a minimum by frequent heating or flashing. Accordingly, the emission exhibits a low noise (short term stability). In addition to that, as the emitter surface is continuously cleaned by frequent flashing (heating pulses), the risk of avalanche desorption and hence uncontrolled emissions is drastically reduced and thereby the life time of the cold field electron emitter is significantly improved. Practically unlimited life times of the cold field emitter with high long term stability are achievable. The frequent heating also ensures that the emitter surface is kept clean despite the vacuum conditions. The emission current can be monitored and used as a control parameter to initiate a cleaning process. In other words, the measured variation of the emission current can be used to trigger the cleaning.

Frequently cleaning as described in more detail below results in a continuously high emission of the emitter (for instance electron emitters such as cold field emitters and photo-emitters) which is much brighter than conventional operated emitters as an emission current near $I_0$ is obtainable. Higher brightness advantageously results in a better optical performance such as a faster image acquisition and a lower image noise.

A single cleaning process may include one or more heating pulses such as for instance 10 heating pulses and, in particular, 2 to 4 heating pulses. The duration of a single heating pulse and the time between consecutive heating pulses can be chosen according to specific needs. The overall duration of a single cleaning process should be kept at minimum to reduce interruptions of normal operation of the electron beam emitting device. During cleaning, the emitter surface is heated to a temperature $T_C$, which can be in the range of about 1800 K to 2500 K and preferably of about 2200 K to 2500 K.

On the other hand, the cleaning process should be repeated as often as required to keep the emission current significantly above the stable mean emission current. For instance, a predefined or predetermined minimum emission reference value $I_C$, which is higher than the stable mean emission value Is, can be defined as $I_C = \alpha I_0$, whereby $\alpha$ can be for instance 0.9, particularly 0.95 and more particularly 0.99. $I_C$ can be used as a reference value defining the lower limit of acceptable emission. If the emission drops to $I_C$, a cleaning process is initiated to clean the emitter surface and to bring the emission back to near the initial emission current $I_0$.

Describing the present method in other words, a cleaning process is initiated when the emission current I has fallen by a factor $\beta = 1-\alpha$ with respect to an initial emission current $I_0$. It is also conceivable to define an initial emission current $I_0$. In this case, $I_0$ is substantially higher than the stable mean emission current $I_S$ so that the emission current $I_C = \alpha I_0$ at which a cleaning process is initiated is also substantially higher than the mean stable emission current $I_S$ to keep the emission well above $I_S$. The emission current therefore oscillates or varies between $I_0$ and $I_C$.

In an aspect of the method for operating an electron beam emitting device a predefined or predetermined maximum value $I_{max}$ and a predefined or predetermined minimum value $I_{min} = I_C > I_S$ are selected, whereby a mean deviation value $\Delta I$ is defined as $\Delta I = I_{max} - I_{min}$ with $\Delta I/I_{max} = \gamma$ and the cleaning process is performed when the emission current has fallen from the maximum emission value $I_{max}$ to $I_{min}$. The values $I_{max}$ and $I_{min}$ are chosen such that they are significantly higher than the mean stable emission current $I_S$. $I_{min}$ equals $I_C$, the pre-defined minimum emission current value. The mean deviation value $\gamma$ is typically small to keep the deviation small. Therefore, the electron emitting device is operated to keep the emission current in a small emission current band well above Is. Hence, the stability of the measured emission current may be chosen as criterion whether or not a cleaning process is required. The width of the emission band, i.e. the maximum deviation is $\Delta I = \gamma\ I_{max}$. Typically, $\gamma$ is about 0.1, particularly about 0.05 and more particularly about 0.02 and most particularly about 0.01.

Further, a method for operating an electron beam emitting device including a cold field emitter having an emitter surface is provided, whereby the method includes the steps of:

(a) placing the cold field emitter in a vacuum of a given pressure, the cold field emitter exhibiting a high initial emission current $I_0$ and a lower stable mean emission current $I_S$ under a given electric extraction field,

(b) applying the given electric extraction field to the cold field emitter for emitting electrons from the emitter surface, so that the emission current of the cold field emitter is higher than the stable mean emission current Is,

(c) adjusting the strength of the electric extraction field to keep the emission current substantially stable and continuously above the mean stable emission current $I_S$ at a predefined value $I_C$ being higher than Is,

(d) performing a cleaning process by applying at least one heating pulse to the cold field emitter for heating the emitter surface to a temperature $T_C$, whereby the cleaning process is performed when the strength of the electric extraction field exceeds a pre-defined reference value, and

(e) repeating the adjusting step (c) and the cleaning process (d) to keep the emission current of the cold field emitter continuously above the substantially stable emission value $I_S$.

To improve stability of the emission current the field strength of the electric extraction field is adjusted to compensate variations of the emission current between consecutive cleaning processes. For instance, by increasing the field strength of the electric extraction field a decline of the emission current due to increasing contamination can be compensated. When the field strength of the electric extraction field, which is typically defined by the voltage U applied to generate the electric extraction field, exceed a predefined reference value, which is correspondingly defined by a reference voltage $U_{max}$, a cleaning process is initiated to clean the emitter surface. The rise of the voltage U required to keep the emission current stable indicates that the contamination of the emitter surface has increased. This increase would, when applying a constant voltage U and hence a constant electric extraction field, otherwise result in an observable decrease of the emission current. Hence, the voltage applied to generate the electric extraction field is used as control parameter to initiate a cleaning process, so that an increase of the voltage applied to keep the emission current stable triggers a cleaning.

The predefined value $I_C$ can be defined as $I_C = \alpha\ I_0$, wherein $\alpha > 0.9$, in particular $\alpha > 0.95$, more particularly $\alpha > 0.98$ and most particularly $\alpha > 0.99$.

The cleaning process can be applied periodically at pre-determined intervals or upon request.

Typically, a master cleaning process is optionally performed at the beginning of the operation. This master cleaning process or master flashing is required to clean the tip from persistent adsorptions such as carbon or other impurities which can be diffused from heating filaments or other components arranged in the electron beam emitting device. The master flashing will be used for new emitter tips and only, when the emission surface of the emitter tip is contaminated and the emission current is distinctly too low. During a master cleaning process, the emitter surface is heated to a temperature $T_{MC}$ which is typically higher than the temperature $T_C$ of the cleaning process. For instance, $T_{MC}$ can be in the range of about 2500 K to 2800 K. Typically, no electric extractor field is generated during a master cleaning process to avoid strong emission from the emitter tip which could otherwise seriously damage the cold field emitter.

In a further embodiment, built-up processes are performed at regular intervals or upon request. A built-up process is a method to sharpen the tip of a cold field emitter. For that purpose, the cold field emitter must be heated to a temperature being high enough to ensure sufficient mobility of surface atoms of the cold field emitter's material. A high electrostatic field needs to be applied to the emitter surface to cause migration of surface atoms toward the emitter apex to re-shape the emitter tip.

In accordance with a further aspect of the above method, the cleaning process is automatically synchronised with non-operational periods of the charged particle beam emitting device or the electron beam emitting device. A non-operational or inactive period of the charged particle beam emitting device or electron beam emitting device typically refers to periods during which the particle beam or the electron beam is defocused or deflected from a sample or specimen. In other words, during non-operational or inactive periods the generated charged particle beam is not used for its intended purpose or function. Such purposes or functions include the scan of a sample or specimen surface for imaging the surface (electron microscopy), microanalysis of a portion of a sample or specimen surface for analysing the chemical composition of the surface and processing of a specimen surface by an electron beam for manufacturing reticles which are used in semiconductor industry as lithographic masks. During non-operational or inactive periods the charged particle beam is generated but not directed onto the sample or specimen surface and/or defocused with respect to this surface. On the other hand, during operational or active periods the particle beam is directed and focused on the sample or specimen surface. Operational and non-operational periods or active and inactive periods, respectively, alternate consecutively. It is worth noting that the normal mode of operation of a charged particle beam emitting device includes operational and non-operational periods, whereby the charged particle beam is continuously generated during normal operation and not interrupted during non-operational periods.

The non-operational periods can be triggered by and hence correspond to an impulse of a timer, a drop of the emission current, an exchange of a sample or specimen, calibration of the particle beam emitting device or electron beam emitting device, a sample or specimen movement and/or a stage movement. During these illustrative events, the particle beam emitting device is not utilised for its intended purpose since, for instance, the sample or specimen is exchanged.

In more general terms, a method for operating a charged particle beam emitting device including a charged particle beam source having an emitter surface is provided, the method includes the steps of:

(a) generating a charged particle beam;

(b) focussing the generated charged particle beam onto a sample or specimen;

(c) automatically performing a cleaning process upon occurring of a triggering event.

The charged particle beam might be defocused or deflected from the sample or specimen during the cleaning process.

In a further aspect, a charged particle beam emitting device is provided including
a charged particle beam source for emitting particles, the charged particle beam source including an emitter surface,
a voltage unit for applying a voltage to the charged particle beam source for generating a charged particle beam,
a heating element for heating the emitter surface,
a control unit including an input for receiving a trigger signal, the control unit being operative to control the heating element to apply at least one heating pulse to the emitter surface of the charged particle beam source during the generation of the charged particle beam upon reception of a trigger signal.

In an embodiment, the charged particle beam emitting device includes a beam blanker, the control unit being operative to control the beam blanker to deflect the generated charged particle beam upon reception of the trigger signal. In a further embodiment the charged particle beam emitting device includes a focussing unit for focussing and defocusing the charged particle beam onto a sample or specimen, the control unit being operative to control the focussing unit to defocus the generated charged particle beam with respect to the sample or specimen upon reception of the trigger signal.

According to another embodiment, the emitter surface of the charged particle beam source has a radius of curvature of less than 250 nm.

The charged particle beam emitting device further comprises a measuring element for measuring the emission current of the charged particle beam source and a triggering unit adapted to provide a trigger signal when the emission current has dropped to a predefined value. Alternatively or in addition to that, the charged particle beam emitting device can comprise a carrying element for movably carrying a specimen, a motion controller unit for controlling the carrying element and a synchronising means adapted to provide a trigger signal upon movement of the carrying element.

BRIEF DESCRIPTION OF THE DRAWINGS

A full and enabling disclosure of the present invention, including the best mode thereof, to one of ordinary skill in the art, is set forth more particularly in the remainder of the specification, including reference to the accompanying figures. Therein:

Figure 1 shows a typical arrangement of an electron beam emitting device.

Figure 2 shows main steps of the method in accordance with one embodiment.

Figure 3 shows a profile of a heating pulse in accordance with an embodiment.

Figure 4 shows a typical emission characteristic of a cold field emitter.

Figure 5 shows the temporal course of the emission current upon controlling the cleaning by employing the emission current as control parameter.

Figure 6 shows the temporal course of the emission current upon controlling the cleaning by employing the voltage applied to generate the electric extraction field as control parameter.

Figure 7 shows main steps for synchronising the cleaning process with triggering events.

Figure 8 shows an arrangement of a particle beam emitting device in accordance with one embodiment.

DETAILED DESCRIPTION OF THE DRAWINGS

Reference will now be made in detail to various embodiments, examples of which are illustrated in the drawings. In the Figures and the description that follows, like reference numerals refer to similar elements. The example is provided by way of explanation, and is not meant as a limitation of the invention. For example, features illustrated or described as part of one embodiment can be used on or in conjunction with other embodiments to yield yet a further embodiment. It is intended that the present invention include such modifications and variations.

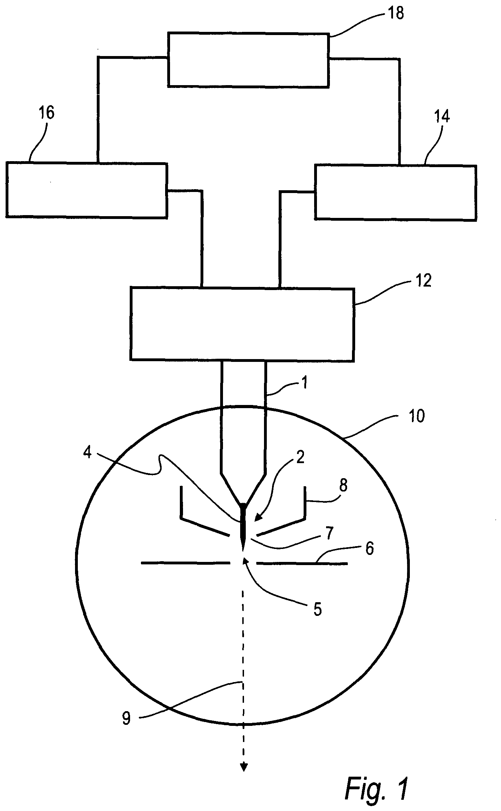

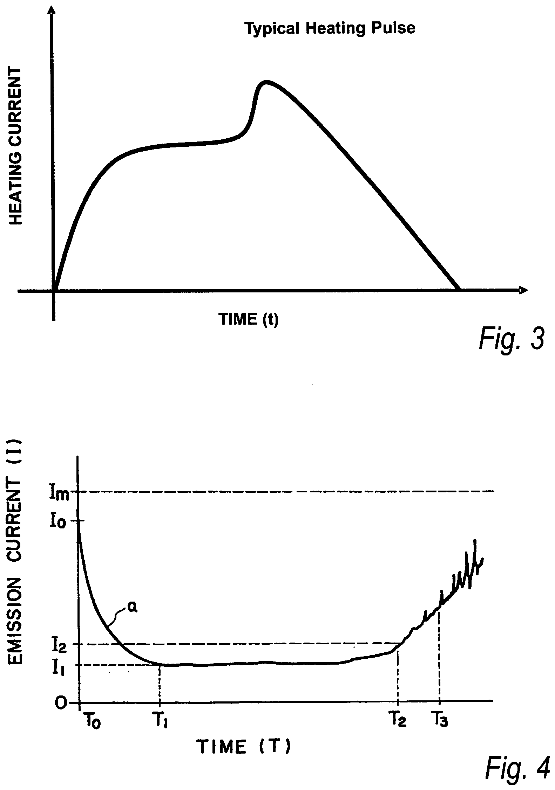

In order to keep the emission current of a cold field emitter at very high level, the cold field emitter and in particular its emitter surface is frequently, for instance periodically, cleaned to remove contaminations adhered to the emitter surface. For a better understanding of the present invention, reference is made to Figure 4 which illustrates a typical emission characteristic of a cold field emitter. Figure 4 is a reproduction of Figure 1 of Okumura et al. (US 4,090,106). Generally, an emitter surface of a cold field emitter is placed in a suitable vacuum which should have a pressure at least less than $1.33 * 10^{-7}$ Pa ($10^{-9}$ Torr) and, in particular, less than $1.33 * 10^{-9}$ Pa ($10^{-11}$ Torr). Let assume for a moment that the emitter surface of the cold field emitter is clean, i.e. it is free from any debris or contaminations. Those skilled in the art are aware that a completely clean emitter surface is practically not available as there are always impurities in the material of the emitter tip itself, impurities emitted from heating filaments and/or residual gas molecules in the vacuum which partially contaminate the emitter surface. Hence, when referring to a clean emitter surface it is meant that the emitter surface is substantially free from debris and contaminations.

A cold field emitter having a clean emitter surface emits a very high emission current. The level of the emission current strongly depends on the field strength of the applied electric extraction field. To observe field emission, the field strength should be in the range of about 10 MVcm$^{-1}$ and above. At such high field strengths, the width of a potential barrier, which exists between the material of the emitter surface and the vacuum, becomes smaller so that the electrons can traverse this barrier by a wave mechanical tunnelling effect. In order to generate such a high electric field in the vicinity of the emission surface, a point-like emitter tip is used having a radius of curvature of about 0.1 $\mu$m or less. As the electric field strength is inversely proportional to the radius of the curvature, only the highly curved surface at the tip forms an effective emitter surface. In the vicinity of less curved portions of the emitter the established electric field is too weak to appreciably extract electrons so that electrons are merely extracted from the tip of cold field emitters which thus forms a point-like electron source.

Still referring to Figure 4, the initial emission current of a clean emitter surface under a given electric extraction field in a given vacuum at time to is represented by $I_0$ indicated at the abscissa. Under further standard operation, i.e. under a constant electric extraction field, constant vacuum condition and at a constant low temperature, the emission current noticeable declines with time due to an increase of gas adsorption on the emitter surface. As the adsorption is increasingly counterbalanced by gas desorption, a dynamical equilibrium of adsorption and desorption comes into being after a certain time which leads to a temporarily stable contamination of the emitter surface. When the dynamical equilibrium or the balanced region is formed, the emission current of the cold field emitter substantially remains constant apart from fluctuations around a stable mean emission current. In Figure 4, the balanced region is reached at time $t_1$ at which the emission current has declined to a value $I_1$ which is substantially lower than the initial emission current $I_0$. A concrete example of an emission characteristic of a cold field emitter is for instance disclosed in W. K. Lo et al., "Titanium nitride coated tungsten cold field emission sources", J. Vac. Sci. Technol. B 14(6), Nov/Dec 1996, 3787-3791. Figure 3(A) of this scientific article shows that the emission current drops from about 800 $\mu$A to about 500 $\mu$A within 300 sec. The emission remains substantially stable for at least an hour. Returning to Figure 4 of the present application, the initial phase between $T_0$, and $T_1$, in which the emission current declines, is often referred to as initial unstable region, and the phase following the initial unstable region, i.e. the region after time $T_1$, is referred to as stable region.

Typically, electron beam emitting devices have been operated in the stable region, i.e. after establishing the balanced condition, to obtain a substantially stable emission over a long period of time. As it becomes clear from Figure 3(A) of W. K. Lo et al., the emission current I in that stable region is substantially lower than the initial emission current of a clean emitter surface.

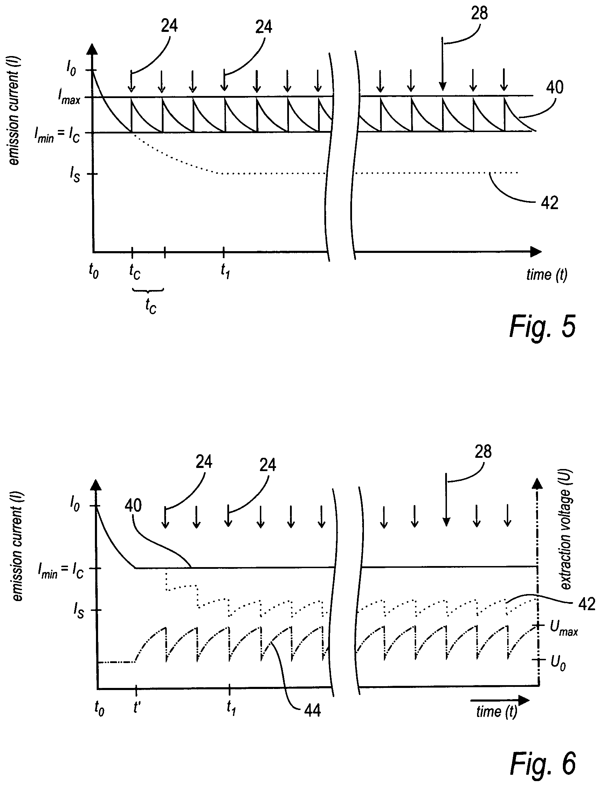

In view of the above, the present invention has been accomplished to increase significantly the emission current and to keep it at high level over a very long period. In accordance with an important concept of the invention, the cold field emitter is operated continuously in the initial unstable region. For this purpose, an initially clean emitter surface is frequently subjected to a cleaning process which removes contaminations from the emitter surface to keep the emission current near the maximum obtainable emission current. The cleaning process is initiated after a lapse of time $t_C$, whereby $t_C$ is between $t_0$ and $t_1$ (in Figure 5), or, in other words, before the emission current has fallen to the mean stable emission value $I_S$ ($I_1$ in Figure 4). After finishing the cleaning process, the emission current rises and particularly reassumes its initial high emission current $I_0$. The cleaning process is repeated after a further period of time $t_C$ has lapsed or when the emission current has fallen to $I_C$, which is a pre-selected reference value between $I_S$ (=$I_1$) and $I_0$. As a result, the emission current varies between $I_C$ and $I_0$ due to the frequent cleaning.

If the initiation of the cleaning process is governed by the drop of the emission current, the emission current needs to be measured by appropriate devices to control the cleaning process. Alternatively or in combination with the above emission current control, the cleaning process can be repeated after pre-defined time intervals which can be chosen such that the emission is continuously kept above the stable mean emission current $I_S$. Control measurements may be performed in advance for particular types of cold field emitters to obtain the specific emission characteristic of each type which than serves as a basis for selecting the respective cleaning intervals.

$I_C$, the value at which a cleaning process is initiated, can be defined as $I_C = \alpha\, I_0$, whereby $\alpha$ can be in the range of about 0.8 to 0.99 and particularly in the range between 0.9 and 0.99. The higher the value of $\alpha$ is chosen, the higher is the mean emission current at which the cold field emitter is operated. On the other hand, a very high $\alpha$ also requires a very frequent repetition of the cleaning process leading to a more frequent switching between active and inactive periods. Hence, the value $\alpha$ should be selected so as to maintain a very high emission current while keeping the interruption low.

It is worth noting that the cleaning process can be repeated more frequently than required with the duration of each single cleaning process being shortened at the same time. In this case, a single cleaning process may include only a single heating pulse (flashing). A single cleaning process might be not enough to clean completely the emitter surface and to bring the emission current back to $I_0$ but is sufficient to bring the emitter surface into the same clean condition as it was after the preceding cleaning process. As the cleaning process is repeated very frequently, the emitter surface is thus kept in a sufficiently clean condition. On the other hand, the level of contamination does not vary very much due to the very frequent and short cleaning processes and hence, the emission current substantially remains stable. The short term stability of the emission current is therefore improved. As an example, the emission current may oscillate or vary between an upper value of about 0.95 $I_0$ and a lower value of about 0.93 $I_0$. In other words, the emission current is kept in an emission current band defined by a maximum value $I_{max}$ and a minimum value $I_{min}$. The difference between $I_{max}$ and $I_{min}$ is defined as $\Delta I = I_{max} - I_{min} = \gamma\, I_{max}$. The width of the emission current band is given by $\Delta I = \gamma\, I_{max}$. When for instance $\gamma$ is about 0.1, then the emission current band has a width which is about 10% of $I_{max}$, whereas $\gamma = 0.05$ would give a width of about 5% of $I_{max}$ and $\gamma = 0.02$ would give a width of about 0.02% of $I_{max}$. The emission current is therefore kept by the frequent cleaning in the emission current band defined by $I_{max}$ and $\gamma$.

It should be noted that the cleaning process is particularly performed when the cold field emitter is working. It should be ensured, that the interruption of the normal mode, i.e. the mode at which the emitted electron beam illuminates a specimen, is kept short as possible. A single cleaning process should be substantially less than 5 minutes. Preferably, a single cleaning process can be less than about 60 seconds or substantially less than that, for example less than 20 or 10 seconds.-The duration of a single cleaning process can be adjusted depending on the level of contamination. Alternatively, the emission current can be controlled during cleaning so that the cleaning process stops when the emission current has assumed its initial emission value or has reached a value close to it.

Typically, the cleaning processes are performed at intervals of more than about 60 sec and particularly of more than about 240 sec or 300 sec. Cleaning of the emitter surface every 4 to 10 minutes (intervals between about 240 sec and about 600 sec) has proved to be sufficient for many applications. The period between consecutive cleaning processes is mainly determined by the quality of the vacuum. By increasing the quality of the vacuum, cleaning processes are less frequent required. As the maintenance of a very or ultra high vacuum is very expensive, a segmentation of the particle beam emitting device into separate compartments having different levels of vacuum is advantageously. For instance, the particle or electron beam emitting device may comprise three chambers. In a first chamber, in which an ultra high vacuum is maintained, the particle beam source is arranged. A second or intermediated chamber is arranged in the direction of the optical axis of the particle beam emitting device. Further down along the optical axis, a third or specimen chamber is arranged. First and second chamber and second and third chamber, respectively, are separated from each other by differential pressure apertures. The pressure in the third chamber is higher than in the second chamber which in turn has a higher pressure than the first chamber. Therefore, the best vacuum is in the first chamber. The different levels of vacuum are maintained by separate vacuum pumps. The segmentation of the particle beam emitting device allows the vacuum in the first chamber, in which the particle beam source is arranged, to be kept at very high level and prevents intrusion of contaminations from the other two chambers, particularly from the third chamber where contaminations are generated due to the interaction of the electron beam with the specimen surface. As a consequence, the first chamber is less likely to be contaminated and, consequently, a cleaning is less frequent required to be performed. Further aspects and details of separated chambers of a particle beam emitting device can be inferred from WO 2005/027175 of the same applicant.

When the electron beam emitting device is an electron microscope used for process diagnostic or wafer inspection during manufacturing of integrated circuits formed on semiconductor wafers, the cleaning process may be applied in combination with imaging or specimen activities. For example, the cleaning process can be carried out only in the interval of an extended frame blanking. For instance, for CD/DR (critical dimension/defect review) wafer inspection, the cleaning process may be done in the swap time between wafer exchanges which is about 10 sec. Other electron beam emitting devices are transmission electron microscopes (TEM) and scanning transmission electron microscopes (STEM) which strongly benefit from the improved brightness and reduced noise gained by the frequent cleaning of their emitters.

A single cleaning process may include one, two or more heating pulses to heat the emitter surface to a sufficiently high temperature $T_C$ to induce decontamination. According to one embodiment, $T_C$ is in the range of about 2200 K to 2500 K. This temperature range is particularly suitable for cold field emitters comprising tungsten. $T_C$ can vary depending on the material used for the emitter. Those skilled in the art can, on the basis of the described method, easily identify suitable temperature ranges for other materials. The pulses width should be short, such as about 1 to 2 sec. An example of a heating pulse is illustrated in Figure 3. The heating pulse shown in Figure 3 is created by applying a controlled electrical current impulse to the cold field emitter so that the cold field emitter including its emitter surface is heated by resistance heating. The current required to heat the emitter surface to a given temperature depends inter alia on the resistance of tungsten wire carrying the cold field emitter. Typically, a single cleaning process includes 2 to 4 heating pulses, each of which having a duration of about 1 to 2 sec. The heating pulses can be applied at intervals of 1 to 3 sec. However, those skilled in the art will appreciate that other numbers of heating pulses, durations and intervals are also possible and can be adjusted according to specific needs.

The temperature, at which the emitter surface is cleaned, should be chosen such that no thickening of the tip radius is induced. At high temperature, the mobility of surface atoms of the cold field emitter's material, for instance tungsten, is increased. However, the material is not melted and the heating temperature is well below the melting temperature of the used material. As the emitter tip is strongly curved, the emitter surface exhibits a high surface tension with a tendency to flatten or to dull the surface. The high surface tension could therefore lead to a re-shaping of the emitter tip. When the cleaning temperature is not too high, the atoms of the cold field emitter's material are not mobile enough to induce re-shaping of the emitter tip.

During heating of the cold field emitter, thermal emission could be induced. As thermal emission would not only occur on the emitter tip, i.e. on the strongly curved emitter surface at the tip, but also on other parts of the cold field emitter surface, a high electron shower could be generated, which could exceed the emission current resulting from field emission. As this temporarily additional thermal emission current can severely damage the emitter tip and/or delicate parts of the electron beam emitting device or a sample arranged in the electron beam emitting device, appropriate measures are required to reduce thermal emission during cleaning. One option is the usage of a so-called suppressor electrode. A suppressor electrode is a specially shaped electrode which is arranged around the cold field emitter. An exemplary arrangement of a suppressor electrode is shown in Figure 1, which is described in detail further below. Typically, the suppressor electrode has a central opening through which the emitter tip projects. A suppressor voltage is applied to the suppressor electrode so that it has a lower electrical potential with respect to the cold field emitter. The suppressor voltage has thus a repulsive effect and suppresses thermal emission. The suppressor voltage should be chosen to substantially suppress any unwanted emission during the cleaning processes. As an example, a suppressor voltage of about 300 V to 1000 V and, preferably, of about 700 V to 1000 V may be applied.

In addition or alternatively to the usage of a suppressor electrode, a beam blanker may be applied during the cleaning process. A beam blanker is an electron beam deflection device which deflects an electron beam by applying an electrostatic or magnetostatic field. The beam blanker is incorporated into the electron beam emitting device between the electron source, i.e. the cold field emitter, and the specimen or sample to be investigated. During cleaning, the beam blanker deflects the electron beam emitted from the cold field emitter so that the electrons do not strike the specimen. As the emission current may rise more than 10 times during cleaning, deflection of this high emission current protects the specimen from damaging.

In order to obtain good cleaning results and to reduce the number of the required cleaning procedures, i.e. to keep the frequency of the cleaning procedures short or, in other words, to keep the intervals between consecutive cleaning processes long, the vacuum should be of high quality. In particular, a vacuum of $6.65 * 10^{-9}$ Pa ($5 * 10^{-11}$ Torr) and, more particularly, of $1.33 * 10^{-9}$ Pa ($10^{-11}$ Torr) or better ensures that the overall level of contamination is comparable small leading to an overall improved emission performance and a less demand for cleaning processes.

In a further embodiment of the invention, built-up processes are performed at regular intervals or upon request.

A built-up process is a method to sharpen the tip of a cold field emitter. For that purpose, the cold field emitter temperature must be raised to a temperature being sufficiently high to ensure surface mobility of the material of the cold field emitter. A high electrostatic field needs to be applied to the emitter surface to cause migration of surface atoms toward the emitter apex. As the surface migration is encountered by the surface tension of the highly curved emitter tip, the field strength of the applied electrostatic field needs to be high enough so that the electrostatic force acting on the surface atoms is higher than the force generated by the surface tension. Periodic built-up processes maintain the shape of the highly curved emitter surface and compensate a slow-progressing dulling of the emitter surface caused by the surface tension and a removal of material during normal operation. A built-up process can be repeated periodically as a precautionary measure or when degradation of the emission current, which is not caused by contamination, is observable.

The re-shaping process is mainly governed by two effects opposing each other. One effect is the tendency of the emitter tip to become elongated under the influence of the electrostatic field and the other effect is the influence of the surface tension which results in a dulling of the emitter tip. The degree to which the emitter tip is re-shaped can be therefore controlled by selecting a certain temperature and field strength of the electrostatic field. If desired, the emitter tip can be re-shaped to assume a pre-selected shape. As the shape, i.e. the radius of the curvature, determines the emission current, the built-up process can be monitored by measuring the emission current. Unlike built-up processes described by Swanson (US 3,817,592) and Frazer, Jr. et al. (US 3,947,716), respectively, the built-up process described above does not require any additional gas to be introduced into the vacuum chamber. Further, as uncoated cold field emitters are typically used, the above built-up process can be applied as no additional coating process is desired as for instance described by Fraser, Jr. et al.

In accordance with embodiments, the temperature range of the built-up process should be in the range of about 2000 K to 3000 K depending on the material and strength of the applied electric field at the emitter tip. Particularly, a pulsed heating is applied. No further gases (e.g. $O_2$) need to be introduced into the vacuum, hence, the partial pressure of any gas components remain constant during the built-up process.

Referring now to Figure 1, an example of an electron beam emission device is illustrated on the basis of a scanning electron microscope (SEM) used for wafer inspection or process diagnostic (CR & DR) in the semiconductor industry. Figure 1 merely shows a so-called electron gun, a device which includes a cold field emitter. However, those skilled in the art appreciate that a SEM includes more components such as electrostatic and magnetostatic lenses, deflectors, beam shapers etc defining the so-called column of the SEM.

In semiconductor industry application, high brightness and high resolution particle beam inspection, review and CD tools are required. In particular, high resolution SEMs are used which strongly benefit from the cleaning method described above. SEMs enable visual inspection of lithographic masks and wafers which allows a fast and easy evaluation of the manufacturing quality. The wafers or masks are transferred from a process chamber into the SEM and, after completion of the inspection, are brought into another chamber. In order to restrict interruption of the inspection and manufacturing process, the exchange time periods required to transfer the wafers or masks into or from the SEM are particularly used for carrying out cleaning processes. Accordingly, the active or operational period, i.e. the time available for inspection, of the SEM is not affected. Furthermore, other inactive or non-operational periods of the SEM tool such as stage movements from one location to another or system calibrations also provide time frames during which the cleaning processes can be initiated. Utilising computer controlled systems, all actions to be taken can be supervised to synchronise emission surface cleaning and system operation.

An electron emission gun of a SEM includes a tungsten wire 1 bent to a U-form. At the bent portion of the tungsten wire 1 a tungsten crystal 4 formed to a very narrow point or tip (emitter surface) 5 is welded. Typically, uncoated polycrystalline tungsten or uncoated mono-crystalline tungsten with an [100] or an [310] orientation is used. The tungsten crystal forms a cold filed emitter 2. The sharp tip 5 points downwards in Figure 1 along an optical axis 9 of the SEM. A cup-shaped suppressor electrode 8 surrounds the cold field emitter and in particular the tungsten crystal 4. At its centre, the suppressor electrode 8 includes an opening 7 through which the tungsten crystal 4 partially extends so that the tip 5 downwardly projects the suppressor electrode 8. An extraction anode 6 is disposed along the optical axis 9 in spaced relation to the suppressor electrode 8 and the emitter tip 5. The extraction anode 6 includes a central opening aligned with the optical axis 9 of the SEM. During normal operation, an extractor voltage is applied between the extraction anode 6 and the cold field emitter 2 so that the extractor anode 6 has a positive potential with respect to the cold field emitter 2. Due to the sharp tip 5, the electric field is highly curved at tip 5 giving rise to high extraction field strength in the vicinity of the tip. On the other hand, the suppressor electrode 8 has a negative potential with respect to the cold field emitter 2 to shield portions of the cold field emitter and the tungsten wire other than the tip from the electric extraction field. The electric suppressor field generated by the applied suppressor voltage substantially weakens the extraction field so that only the tip is exposed to the extraction field. During cleaning, the electric suppressor field suppresses unwanted thermal emission from the cold field emitter.

The cold field emitter 2 is disposed in a high vacuum chamber 10 along with other parts of the SEM. The vacuum should be in the range better than $6.65 * 10^{-9}$ Pa ($5 * 10^{-11}$ Torr). The better the vacuum (i.e. the lower the pressure) the slower the emitter surface becomes contaminated. As noted above, the vacuum chamber 10 can be formed by a plurality of vacuum sub-chambers separated from each other by appropriate differential pressure apertures.

The tungsten wire 1 is connected to a heating current source 12 which is controlled by a heating current controller 16. The heating current controller 16 defines the length, amplitude and width of the heating pulse. An overall system control computer 18 connected with the heating current controller 16 triggers the cleaning process and synchronises it with the inspection cycle. The overall system control computer 18 also controls the suppressor and extraction voltages and an HV-source 14 connected with the heating current source.

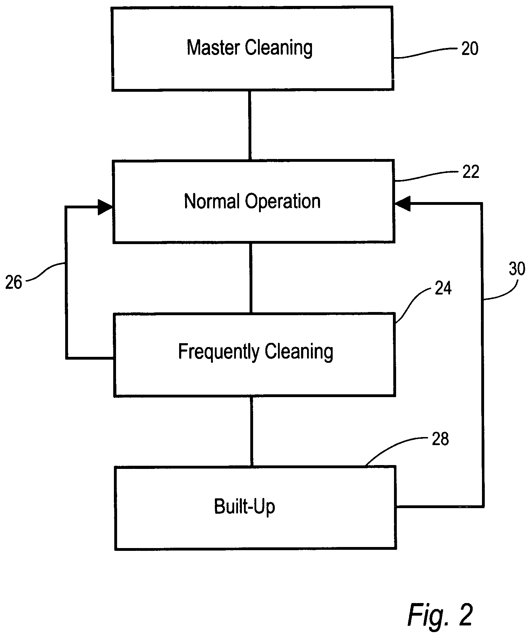

Referring to Figure 2, a process of sequences in according to one embodiment is described.

At the beginning of the operation and, particularly, when a new cold field emitter has been assembled into the electron beam emitting device, a master cleaning process (20) is carried out to clean the emitter surface from any persistent contamination. The master cleaning process typically employs short and strong heating pulses (master flashing) which heat the emitter surface to a temperature $T_{MC}$ of about 2500 K to 2800 K. During master cleaning, the extractor voltage applied between cold field emitter and extraction anode should be turned off so that emission of thermal electrons is kept low.

After master cleaning (20), the cold field emitter is brought into normal operation (22) by applying an electric extraction field. Cold field emitters are operated at room temperature without any additional heating so that the electron emission is only field induced. During normal operation, an electron beam is generated and directed onto a specimen to be investigated.

Normal operation (22) or the active period of the SEM is than briefly interrupted to perform a cleaning process (24). Interruption of the normal mode means that the electron beam is not focussed onto the specimen. It is therefore possible to maintain the operating conditions of the normal mode and, for example, to deflect the electron beam using a beam blanker. Hence, the cleaning process is generally initiated when the cold field emitter is working unlike the prior art which performs a cleaning step when the fluctuations of the emission current become intolerable and the operation of the electron beam emitting device is therefore terminated.

Heating pulses are applied during the cleaning process (24) to the cold field emitter to heat the emitter surface to a maximum temperature of about 2200 K to 2500 K. The maximum temperature should be lower than the temperature at which dulling or thickening of the emitter tip due to high surface tension is observed. As an example, a single cleaning process includes 2 to 4 heating pulses having a pulse width of about 1 to 2 sec at 1 to 3 sec intervals. The duration of a single cleaning process should be as short as possible to keep the interruption of the normal mode as small as possible. For instance, a cleaning process should be shorter than 1 minute and particularly less then 10 sec.

To avoid damage of the emitter surface during cleaning, a high suppressor voltage of about 300 V to 1000 V and, preferably, of about 700 V to 1000 V is applied which inhibits unwanted emission from heated portions of the cold field emitter.

The cleaning process (24) is repeated (26) as often as required to keep the emitter surface clean. The cleaning process can be initiated at regular intervals or upon request when the emission current drops to a pre-selected minimum value $I_C$ defined as $\alpha\, I_0$ with $\alpha$ about 0.9 or higher such as 0.95, 0.96, 0.97, 0.98 or, in particular, 0.99. The higher $\alpha$ is, the higher $I_C$ is and the more frequently the cleaning process is performed. The value $\alpha$ should be chosen such that $I_C$ is substantially higher than the stable mean emission current $I_S$ of a particular cold field emitter. As shown in the article of W. K. Lo et al. referred to above, a typical mean stable emission current is about only 60% of the initial high emission current. Hence, when choosing $\alpha = 0.9$, the emitter surface is kept clean to have a minimum emission of about 90% of the initial high emission $I_0$. A value of 0.95 would give a minimum emission of 95% and $\alpha = 0.99$ would give 99%. Therefore, the cold field emitter is operated in the initial unstable region at which the contamination is unbalanced as described above. As the contamination is continuously kept at minimum, adverse effects on the emitter surface are substantially reduced leading to a long-time stability and long life time of the cold field emitter.

The cleaning process (24) can be for instance started after a pre-selected time interval or can be synchronised with inactive or non-operational periods of the SEM to transfer specimens to be investigated. A fixed time interval is typically determined with respect to the quality of the vacuum applied, the type of cold field emitter used and the value $I_C > I_S$ defining the minimum emission current. Alternatively or in combination with a fixed time interval, the emission current can be monitored to initiate the next cleaning process when the emission current has dropped to a pre-selected $I_C$ or when the emission current tends to become unstable.

Further, the cleaning process is performed such that the emission current I is kept between $I_C$ as a minimum value $I_{min}$ and $I_{max}$ being lower than $I_0$. The emission current thus oscillates or varies between $I_{min} = I_C$ and $I_{max}$.

With reference to Figure 5 the temporal course of the emission current I is shown. Let assume that a clean emitter tip is provided at time to. Under a given and constant electric extraction field generated by a given and constant voltage U applied between the emitter tip and the extraction electrode and under a given vacuum an emission current I is generated which has a high initial emission current $I_0$ at to. Upon further operation under constant conditions the emission current I decreases and assumes a lower stable mean current $I_S$ at $t_1$. The decrease of the emission current results from increasing contamination of the emitter surface over time. The typical emission characteristic of a cold field emitter under given constant conditions with no frequent cleaning is indicated in Figure 5 by a dotted line 42.

In contrast thereto, the emission characteristic of a cold field emitter under the same condition but with frequent cleaning of the emitter surface is indicated by a bold line 40 in Figure 5. As shown in Figure 5, a first cleaning process 24 is carried out when the emission current I has dropped to $I_{min} = I_C$. The cleaning processes are indicated by small arrows 24. $I_{min}$ defines the lower range of the desired emission current and is a predefined value significantly higher than $I_S$. After cleaning, the emission current rises to a value $I_{max}$. $I_{max}$ is shown in Figure 5 as being lower than $I_0$ but can also equal $I_0$. The emission current I obtained after cleaning depends on the intensity of the cleaning process which is governed by the temperature, duration and number of the heating pulses applied. Upon further operation under constant condition, i.e. constant electric extraction field and given vacuum condition, the emission current declines again. A further cleaning process 24 is carried out when the emission current I has dropped again to $I_{min}$. The cleaning process is repeated as often as required and, as indicated in Figure 5, is triggered when the emission current has dropped to $I_{min}$. Hence, the control parameter to control the cleaning process is the emission current I which needs to be monitored. By employing this approach, the emission current I oscillates or varies between $I_{min}$ and $I_{max}$. Those skilled in the art will appreciate that the cleaning processes can be also performed without monitoring the emission current. In this case, the cleaning is performed at fixed intervals which can be predefined depending on the type of the cold field emitter used.

After a prolonged period of time, a built-up process 28 indicated by a big arrow in Figure 5 can be performed to compensate slow-progressing deformations of the emitter tip.

Referring now to Figure 6, the temporal course of the emission current I is exemplified for the case that the voltage U applied to generate the electric extraction field is adjusted between consecutive cleaning processes to keep the emission current stable. As in Figure 5, dotted line 42 indicates the typical emission characteristic of a cold field emitter without frequent cleaning. The difference between the characteristics 42 shown in Figure 5 and 6 is that in Figure 6 the voltage U applied is adjusted to compensate the decline of the emission current I. Without any cleaning the emission I declines to $I_S$ at about $t_1$ and varies then about $I_S$ due to the variation of the voltage U, the temporal course of which is indicated by dashed and dotted line 44.

In contrast to the emission characteristic without frequent cleaning, the emission current I illustrated by bold line 40 remains substantially stable due to frequently cleaning and the compensation between consecutive cleaning processes. In Figure 6, the applied voltage $U_{min}$ is initially kept constant over a period t'. During this period the emission current declines from $I_0$ to $I_{min}$. At time t' the compensation of the decline begins by an increase of the voltage U. The voltage U is adjusted such that the emission current I remains substantially constant at $I_{min}$. To compensate the decline of emission current, the voltage U needs to be increased, and upon reaching a predefined value $U_{max}$, a cleaning process 24 is performed to clean the emitter surface. After cleaning, the emitter surface exhibits substantially the same emission characteristic as at time t' so that the applied voltage U can be reduced to the initial voltage $U_0$ to keep the emission constant. As the contamination of the emitter surface increases again, the voltage U needs to be adjusted as well and, particularly, needs to be increased to compensate an otherwise observable decline of the emission current. The voltage U applied is therefore an indirect measure of the emission quality and a cleaning process is triggered when a predefined voltage value $U_{max}$ has been reached. Hence, the applied voltage U is in this embodiment the control parameter to control the cleaning process. For this control, the emission current needs to be monitored as well.

It is also possible to start with the compensation at time to so that the emission current can be kept at $I_0$ or very close to it.

As in Figure 5, built-up processes 28 can be performed upon request or when the emission quality is affected by slow-progressing deformations or dulling of the emitter surface.

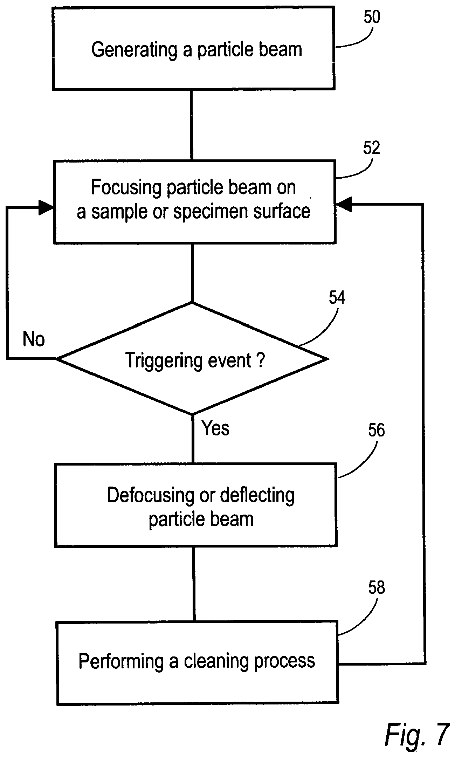

Now referring to Figure 7 which illustrates the initiation of the cleaning process in dependence of the occurrence of a triggering event. During normal operation, a particle beam is generated (50) and focussed (52) onto the specimen or sample surface, for instance, to scan its surface. This period is referred to as active or operational period. Upon occurring of a triggering event (54) the particle beam emitting device is rendered inactive, i.e. it temporally interrupts its operation. Such triggering events may include a decline of the emission current or the rise of the extraction voltage to $U_{max}$ as described above. Further events are a sample or specimen exchange which, for example, occurs in high-throughput inspection or process diagnostic (CD & DR) of processed semiconductor wafers. The typical duration of such an exchange is about 10 sec. A further option includes a signal generated by a timer. The timer periods can be set based on experience or on preliminary tests made for determining the emission characteristic of a particular particle beam source. Time periods required to calibrate the particle beam emitting device and periods for moving the specimen or sample or the stage on which the specimen is arranged may also be utilised and form triggering events for a short period. Common to these exemplary events is that they interrupt or prevent the intended purpose or function of the particle beam emitting device. For example, during these events no scan of the specimen surface is carried out.

During the inactive or non-operational period initiated and defined by the triggering event the particle beam is deflected or defocused to avoid damaging of the specimen. Further, a cleaning process is automatically initiated to clean the emitter surface of the particle or electron beam source. Typically, the generation of a particle or electron beam is not interrupted during the inactive periods and the cleaning process. This allows a rapid return to the active period or a rapid switching between inactive and active periods. Further, it enables an instant verification and control of the cleaning process. After completing the cleaning process the particle beam emitting device switches back to its active state.

It is also possible that a decision whether or not a cleaning process is initiated depends on the occurrence of two or more events. For instance, a cleaning process is performed during specimen or sample exchange only if the emission current has declined to $I_{min}$.

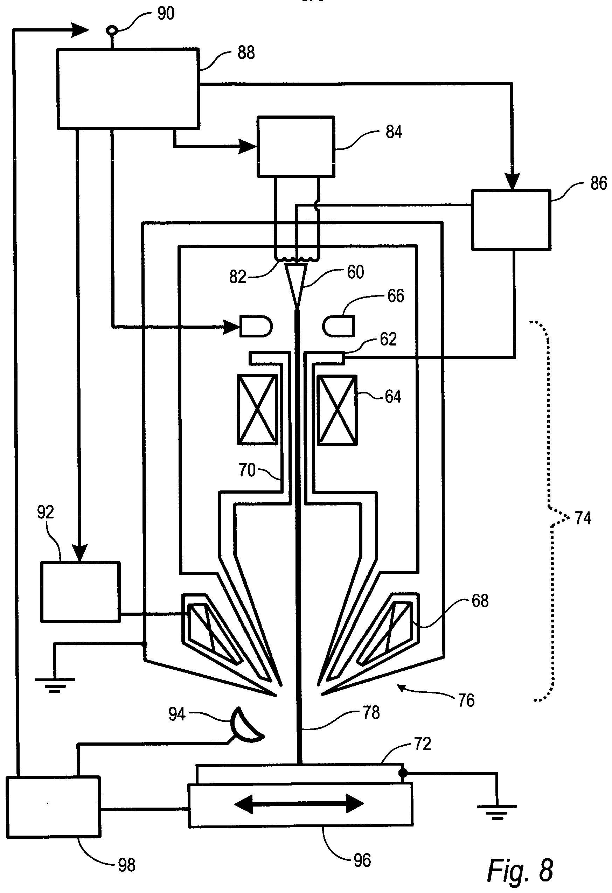

With reference to Figure 8 a particle beam emitting device is described. The embodiment shown in Figure 8 has a particle beam source 60 including an emitter surface, an extraction electrode and a suppressor electrode not shown. Figure 8 is for illustrative purpose and is not drawn to scale.

The particle beam source 60 generates a charged particle beam 78 which is in this embodiment an electron beam. The electron beam 78 is accelerated by an anode 62 to energy of about 10 keV and guided through a high voltage beam column 70 towards a sample or specimen 72. The high voltage beam column 70 serves to keep the electrons of the electron beam 78 at high energy before their deceleration. The high energy of the electrons during their passage through the beam optical system 74 helps to minimize diffusion and spreading of the electron beam 78.

In addition to the above mentioned components, the beam optical system 74 in Figure 8 comprises a condenser 64 and a final focus lens 76 to focus the electron beam 78 onto the specimen 72. The final focus lens 76 in this embodiment focuses the electron beam by means of a combination of a magnetic field generated by a final focus magnet coil 68 and an electric field generated by the voltage applied between specimen 72 and high voltage beam column 70. The high voltage beam column 70 is electrically connected to anode 62 in order to provide an electric field free region for transporting the electron beam 78 towards the specimen 72. In the region between the final focus lens 76 and specimen 72, the electron beam 78 becomes decelerated to a desired final energy at which the specimen is meant to be inspected. A beam blanker or deflector 66 is arranged between particle beam source 60 and specimen 72 for deflecting the particle beam off the specimen surface. It is for clarity purposes of the drawings only that the beam optical system 74 illustrated in Figure 8 shows only some of the components which are usually implemented in a SEM. For example, it does not show apertures, deflectors for scanning the specimen surface or detectors for secondary electrons. However, a skilled person will appreciate that the illustrative SEM of Figure 8 may include additional components depending on the application of the SEM.

By employing the beam blanker 66 a particle beam such as an electron beam or ion beam emitted from particle beam source 60 can be deflected during the cleaning process. Alternatively, the particle beam may become defocused by the final focus lens 76. Further, the particle beam can also be kept focussed without deflecting it if, for instance, the emission current does not exceed an upper critical limit during cleaning or if no specimen is arranged in the particle beam emitting device. For cleaning the emitter surface the particle beam source 60 includes a heating element 82 for applying heating pulses to the emitter surface. Examples of heating elements are a resist heater such as the tungsten wire of a cold field emitter and a laser beam directed onto the emitter surface. Instead of using the tungsten wire a separated resistance heater can be used as well. Heating element 82 is controlled by a heating control unit 84. The high voltage applied to particle beam source 60 and anode 62 is controlled by voltage unit 86, and the final focus magnet coil 68 is controlled by a focussing unit 92. A control unit 88 having an input 90 is provided for controlling the heating control unit 84, voltage unit 86, beam blanker 66 and focussing unit 92.

Upon reception of a trigger signal by input 90, control unit 88 initiates a cleaning process by prompting the heating control unit 84 to apply heating pulses to the emitter surface. At the same time, the particle beam 78 being continuously generated is deflected by beam blanker 66 or defocused by the final focus lens 76. Control unit 88 provides an overall control of the individual components.

The trigger signal can be provided by a triggering unit or synchronising means 98 which is operatively connected with a measuring element 94 for measuring the emission current and with a motion controller for controlling the movement of a carrying element 96. The motion controller is not shown in Figure 8. The carrying element 96 can be for instance a stage for holding the specimen during inspection or imaging or can be a transfer unit for transferring the specimen into and out of the charged particle beam emitting device. Movements of the carrying elements, which may result in the generation of a trigger signal, are stage movement to expose different portions of the specimen to the charged particle beam and a specimen exchange.

Returning back to Figure 2, a built-up process (28) is periodically or sporadically executed in addition to the frequent cleaning to sharpen the emitter tip and to reverse adverse effects resulting from frequently heating. As an example, although the temperature of the cleaning processes is kept sufficiently low to prevent observable dulling or flattening of the emitter tip, over a long period including very many cleaning processes the emitter tip gradually tends to become dull which means that the radius of the emitter tip's curvature decreases. As the electric field strength at the emitter tip is inversely proportional to the radius of the tip curvature, the dulling results in a decrease of the electric filed strength at the emitter surface and thus to an observable reduction of emission current. A built-up is typically carried out when the emission current tends to become unstable or has an intolerable beam quality.

The built-up process (28) is carried out by applying heating pulses to the emitter tip under the presence of a strong electrostatic field. A high electrostatic field causes a transfer of the emitter tip's material towards its apex so that the emitter tip becomes more elongated and sharper. Those skilled in the art will appreciate that the electrostatic force generated by the applied electric field needs to be higher than the force generated by the surface tension of the heated emitter tip. The temperature, upon which the emitter tip is heated, is about 2000 K to 3000 K. The polarity of the applied electric field is of no importance, hence, a polarity of the electric field reverse to the polarity of an electric extraction field can be used which ensures that no field emission occurs and that thermal emission is substantially suppressed. For applying the constant electrostatic field, a suitable voltage is applied to the extractor electrode. The voltage applied during built-up is typically higher than the extractor voltage. The required field strength $F_0$ for a built-up process follows from equation (1)

$$F_0 > \frac{8.1 \times 10^4}{\sqrt{r}} (V/cm) \qquad (1)$$

where r is the tip radius in cm. For an emitter tip radius of 50 nm, the corresponding field strength should be higher than $3.6 \times 10^7$ V/cm.

The form of the heating pulses applied during the built-up processes (28), i.e. the pulse width and amplitude, may play an important role in the efficiency of the built-up process. As an example, a single heating pulse may have a width of about 1 to 2 sec. Typically, 5 to 10 heating pulses are required to sharpen the emitter tip.

It is worth noting that built-up processes and cleaning processes are different processes. The main difference between cleaning and built-up for a given emitter tip is that the temperature, at which the emitter tip is heated, is lower during a cleaning process than during a built-up process so that the emitter tip's material is not mobile enough to experience observable re-shaping during a cleaning process.

During a built-up process, the emission current of the emitter tip or the emission surface, respectively, can be measured to monitor the built-up process. The built-up process is terminated when the desired strength of the emission current is detected.

Unlike prior art built-up processes, the built-up process (28) described above does not require extra gas to adjust the partial pressure of a particular gas component (e.g. $O_2$). Further, multiple heating pulses are used instead of a constant heating.

Built-up processes (30) are regularly repeated (32), however less frequent than the cleaning process. Typically, a built-up process is initiated upon detection of unstable or decreased emission current.

To obtain best results, a suitable combination of master cleaning, frequent cleaning and built-up process is desired to obtain a high stability of emission current (for instance about 1 %), a high brightness of the cold field emitter and practically unlimited life time of the cold field emitter.

Having thus described the invention in detail, it should be apparent for a person skilled in the art that various modifications can be made in the present invention without departing from the scope of the following claims.

**Claims**

1. Method for operating a charged particle beam emitting device comprising a charged particle beam source (2, 60) having an emitter surface (5), the method comprising the steps of:

(a) placing the charged particle beam source (2, 60) in a vacuum of a given pressure, the charged particle beam source (2, 60) exhibiting a high initial emission current $I_0$ and a lower stable mean emission current $I_S$ under given operational conditions,
(b) applying the given operational conditions to the charged particle beam source (2, 60) for emitting charged particles from the emitter surface (5), so that the emission current of the charged particle beam source is higher than the stable mean emission current Is,
(c) performing a cleaning process by applying at least one heating pulse to the charged particle beam source for heating the emitter surface (5) to a temperature $T_C$, whereby the cleaning process is performed before the emission current of the charged particle beam source has declined to the lower stable mean emission value $I_S$, and
(d) repeating the cleaning process (c) to keep the emission current of the charged particle beam source continuously above the substantially stable emission value $I_S$.

2. Method as claimed in claim 1, wherein the cleaning process (c) is performed at predefined time intervals or when the emission current has dropped to a predefined value $I_C$, whereas $I_C$ is higher than the stable mean emission value $I_S$.

**3.** Method as claimed in claim 2, wherein $I_C$ is defined as $I_C = \alpha\, I_0$ with $\alpha > 0.9$ and in particular $\alpha > 0.95$.

**4.** Method as claimed in any of the preceding claims, wherein a predefined maximum value $I_{max}$ and a predefined minimum value $I_{min} = I_C >$ is is selected, whereby a mean deviation value $\Delta I$ is defined as $\Delta I = I_{max} - I_{min}$, and the cleaning process is performed when the emission current has fallen from the maximum emission value $I_{max}$ to $I_{min}$.

**5.** Method as claimed in any of the preceding claims, wherein $\Delta I/I_{max} = \gamma$, and $\gamma$ is about 0.1 and in particular about 0.05.

**6.** Method as claimed in any of the preceding claims, wherein

the charged particle beam emitting device is an electron beam emitting device,
the charged particle beam source is an electron emitter for emitting electrons and
the given operational conditions comprises a given pressure and a given energy applied to the emitter surface of the electron emitter to extract electrons.

**7.** Method as claimed in claim 6, wherein the electron emitter is a cold field emitter and the energy is an electric field.

**8.** Method as claimed in any of the preceding claims, wherein

the charged particle beam emitting device is an ion beam emitting device, and
the charged particle beam source is an ion emitter for emitting ions.

**9.** Method for operating an electron beam emitting device comprising a cold field emitter (2, 60) having an emitter surface (5), the method comprising the steps of:

(a) placing the cold field emitter (2, 60) in a vacuum of a given pressure, the cold field emitter (2, 60) exhibiting a high initial emission current $I_0$ and a lower stable mean emission current $I_S$ under a given electric extraction field,
(b) applying the given electric extraction field to the cold field emitter (2, 60) for emitting electrons from the emitter surface (5), so that the emission current of the cold field emitter is higher than the stable mean emission current Is,
(c) adjusting the strength of the electric extraction field to keep the emission current substantially stable and continuously above the mean stable emission current $I_S$ at a predefined value $I_C$ being higher than $I_S$,
(d) performing a cleaning process by applying at least one heating pulse to the cold field emitter for heating the emitter surface (5) to a temperature $T_C$, whereby the cleaning process is performed when the strength of the electric extraction field exceeds a predefined reference value, and
(e) repeating the adjusting step (c) and the cleaning process (d) to keep the emission current of the cold field emitter continuously above the substantially stable emission value $I_S$.

**10.** Method as claimed in claim 9, wherein the predefined value $I_C$ is defined as $I_C = \alpha\, I_0$, wherein $\alpha > 0.9$ and in particular $\alpha > 0.95$.

**11.** Method as claimed in any of the preceding claims, wherein $T_C$ is about 2200 K to 2500 K.

**12.** Method as claimed in any of the preceding claims, wherein the pulse width of the at least one heating pulse is 1 sec to 2 sec.

**13.** Method as claimed in any of the preceding claims, wherein each cleaning process comprises about 10 heating pulses and, in particular, 2 to 4 heating pulses being applied to the particle beam source or cold field emitter about every 1 sec to 3 sec.

**14.** Method as claimed in any of the claims 6 to 12, wherein the electron beam emitting device comprises a suppressor electrode (8) arranged around the emitter or cold field emitter, and wherein a suppressor voltage is applied to the suppressor electrode (8) during the cleaning process.

**15.** Method as claimed in claim 14, wherein the suppressor voltage is between 300 V and 1000 V.

**16.** Method as claimed in any of the preceding claims, wherein step (a) comprises a master cleaning process for cleaning the emitter surface (5) such that the charged particle beam source or cold field emitter exhibits the high initial emission

current $I_0$ and the lower stable mean emission current $I_S$.

**17.** Method as claimed in claim 16, wherein the master cleaning process comprises at least one master heating pulse to heat the emitter surface to a temperature $T_{MC}$.

**18.** Method as claimed in claim 16 or 17, wherein $T_{MC}$ is about 2500 K to 2800 K.

**19.** Method as claimed in any of the preceding claims, wherein the charged particle beam source or the cold field emitter has an emitter tip at which the emitter surface is formed and wherein a thermal built-up process (f) is performed to sharpen the emitter tip.

**20.** Method as claimed in claim 19, wherein multiple heating pulses are applied to the charged particle beam source or the cold field emitter (2, 60) during the built-up process (f).

**21.** Method as claimed in claim 20, wherein the heating pulses heat the emitter surface to a temperature $T_B$, which is higher than the temperature $T_C$ of the cleaning process.

**22.** Method as claimed in any of the preceding claims, wherein the cleaning process is automatically synchronised with non-operational periods of the charged particle beam emitting device or the electron beam emitting device.

**23.** Method as claimed in claim 22, wherein the non-operational periods are periods during which the charged particle beam or the electron beam is defocused or deflected from a sample or specimen.

**24.** Method as claimed in claim 22 or 23, wherein the non-operational periods are triggered by an impulse of a timer, a drop of the emission current, particularly as defined in any of the claims 1 to 21, an exchange of a sample or specimen, calibration of the charged particle beam emitting device or electron beam emitting device, a sample or specimen movement and/or a stage movement.

**25.** Charged particle beam emitting device, comprising:

a charged particle beam source (60) for emitting charged particles, the charged particle beam source comprising an emitter surface (5),
a voltage unit (86) for applying a voltage to the charged particle beam source (66) for generating a charged particle beam (78),
a heating element (82) for heating the emitter surface (5),
a control unit (88) comprising an input (90) for receiving a trigger signal, the control unit (88) being operative to control the heating element (82) to apply at least one heating pulse to the emitter surface (5) of the charged particle beam source (60) during the generation of the charged particle beam (78) upon reception of a trigger signal,
**characterised in that** the charged particle beam emitting device further comprises a measuring element (94) for measuring the emission current of the charged particle beam source (60), and a triggering unit (98) adapted to provide the trigger signal when the emission current has dropped to a predefined value.

**26.** Charged particle beam emitting device as claimed in claim 25, wherein the charged particle beam emitting device comprises a beam blanker (66), the control unit (88) being operative to control the beam blanker (66) to deflect the generated particle beam (78) upon reception of the trigger signal.

**27.** Charged particle beam emitting device as claimed in claim 25, wherein the charged particle beam emitting device comprises a focussing unit (92) for focussing and defocusing the charged particle beam (78) onto a sample or specimen (72), the control unit (88) being operative to control the focussing unit (92) to defocus the generated charged particle beam (78) with respect to the sample or specimen (72) upon reception of the trigger signal.

**28.** Charged particle beam emitting device as claimed in any of the claims 25 to 27, wherein the charged particle beam emitting device is an electron beam emitting device and the charged particle beam source is an electron emitter and in particular a cold field electron emitter.

**29.** Charged particle beam emitting device as claimed in claim 28, wherein the electron beam emitting device is a scanning electron microscope (SEM), a transmission electron microscope (TEM) or a scanning transmission electron microscope (STEM).

**30.** Charged particle beam emitting device as claimed in any of the claims 25 to 27, wherein the charged particle beam emitting device is an ion beam emitting device and the charged particle beam source is an ion emitter.

**31.** Charged particle beam emitting device as claimed in any of the claims 25 to 30, wherein the emitter surface of the charged particle beam source (60) has a radius of curvature of less than 250 nm.

**32.** Charged particle beam emitting device as claimed in any of the claims 25 to 31, wherein the charged particle beam emitting device comprises a carrying element (96) for movably carrying a specimen, a motion controller unit for controlling the carrying element (96) and a synchronising means (98) adapted to provide a trigger signal upon movement of the carrying element (96).

**33.** Charged particle beam emitting device, comprising:

a charged particle beam source (60) for emitting charged particles, the charged particle beam source comprising an emitter surface (5),
a voltage unit (86) for applying a predetermined voltage to the charged particle beam source (66) for generating a charged particle beam (78),
a heating element (82) for heating the emitter surface (5),
a control unit (88) comprising an input (90) for receiving a trigger signal, the control unit (88) being operative to control the heating element (82) to apply at least one heating pulse to the emitter surface (5) of the charged particle beam source (60) during the generation of the charged particle beam (78) upon reception of a trigger signal,
**characterised in that** the charged particle beam emitting device further comprises a measuring element (94) for measuring the emission current of the charged particel beam source (60), and a triggering unit (98) adapted to provide the trigger signal when the predetermined voltage applied by the voltage unit (86) exceeds a predefined voltage value ($U_{max}$).

## Patentansprüche

**1.** Verfahren zum Betreiben einer Emissionsvorrichtung eines Strahls geladener Teilchen, welche eine Quelle (2, 60) des Strahls geladener Teilchen umfasst, die eine Emitter-Oberfläche (5) aufweist, wobei das Verfahren die folgenden Schritte umfasst:

(a) Platzieren der Quelle (2, 60) des Strahls geladener Teilchen in ein Vakuum mit einem gegebenen Druck, wobei die Quelle (2, 60) des Strahls geladener Teilchen einen hohen Anfangsemissionsstrom $I_0$ und einen niedrigeren, stabilen mittleren Emissionsstrom $I_S$ unter gegebenen Betriebsbedingungen aufweist,
(b) Anwenden der gegebenen Betriebsbedingungen auf die Quelle (2, 60) des Strahls geladener Teilchen, um geladene Teilchen von der Emitter-Oberfläche (5) zu emittieren, so dass der Emissionsstrom der Quelle des Strahls geladener Teilchen höher ist als der stabile mittlere Emissionsstrom $I_S$,
(c) Durchführen eines Reinigungsprozesses, indem mindestens ein Heizimpuls auf die Quelle des Strahls geladener Teilchen angewendet wird, um die Emitter-Oberfläche (5) auf eine Temperatur $T_C$ zu heizen, wobei der Reinigungsprozess durchgeführt wird, bevor der Emissionsstrom der Quelle des Strahls geladener Teilchen auf den niedrigeren, stabilen mittleren Emissionswert $I_S$ zurückgegangen ist, und
(d) Wiederholen des Reinigungsprozesses (c), um den Emissionsstrom der Quelle des Strahls geladener Teilchen kontinuierlich über dem im Wesentlichen stabilen Emissionswert $I_S$ zu halten.

**2.** Verfahren nach Anspruch 1, wobei der Reinigungsprozess (c) in vorbestimmten Zeitabständen durchgeführt wird oder durchgeführt wird, wenn der Emissionsstrom auf einen vordefinierten Wert $I_C$ abgesunken ist, wobei $I_C$ höher ist als der stabile mittlere Emissionswert $I_S$.

**3.** Verfahren nach Anspruch 2, wobei $I_C$ als $I_C = \alpha\ I_0$ definiert ist, wobei $\alpha > 0,9$ und insbesondere $\alpha > 0,95$ ist.

**4.** Verfahren nach einem der vorhergehenden Ansprüche, wobei ein vordefinierter Höchstwert $I_{max}$ und ein vordefinierter Mindestwert $I_{min} = I_C > I_S$ ausgewählt wird, wobei ein mittlerer Abweichungswert $\Delta I$ als $\Delta I = I_{max} - I_{min}$ definiert ist, und der Reinigungsprozess durchgeführt wird, wenn der Emissionsstrom vom höchsten Emissionswert $I_{max}$ auf

$I_{min}$ gesunken ist.

5. Verfahren nach einem der vorhergehenden Ansprüche, wobei $\Delta I/I_{max} = \gamma$ ist, und $\gamma$ ca. 0,1 und insbesondere ca. 0,05 beträgt.

6. Verfahren nach einem der vorhergehenden Ansprüche, wobei
es sich bei der Emissionsvorrichtung des Strahls geladener Teilchen um eine Elektronenstrahlemissionsvorrichtung handelt,
es sich bei der Quelle des Strahls geladener Teilchen um einen Elektronenemitter zum Emittieren von Elektronen handelt, und
die gegebenen Betriebsbedingungen einen gegebenen Druck und eine gegebene Energie umfassen, die an die Emitter-Oberfläche des Elektronenemitters angelegt werden, um Elektronen herauszulösen.

7. Verfahren nach Anspruch 6, wobei es sich bei dem Elektronenemitter um einen Kaltfeldemitter und bei der Energie um ein elektrisches Feld handelt.

8. Verfahren nach einem der vorhergehenden Ansprüche, wobei
es sich bei der Emissionsvorrichtung des Strahls geladener Teilchen um eine Ionenstrahl-Emissionsvorrichtung handelt, und
es sich bei der Quelle des Strahls geladener Teilchen um einen Ionenemitter zum Emittieren von Ionen handelt.

9. Verfahren zum Betreiben einer Elektronenstrahlemissionsvorrichtung, die einen Kaltfeldemitter (2, 60) mit einer Emitter-Oberfläche (5) umfasst, wobei das Verfahren die folgenden Schritte umfasst:

   (a) Platzieren des Kaltfeldemitters (2, 60) in ein Vakuum mit einem gegebenen Druck, wobei der Kaltfeldemitter (2, 60) einen hohen Anfangsemissionsstrom $I_0$ und einen niedrigeren, stabilen mittleren Emissionsstrom $I_S$ unter einem gegebenen elektrischen Extraktionsfeld aufweist,
   (b) Anwenden des gegebenen elektrischen Extraktionsfelds auf den Kaltfeldemitter (2, 60), um Elektronen von der Emitter-Oberfläche (5) zu emittieren, so dass der Emissionsstrom des Kaltfeldemitters höher ist als der stabile mittlere Emissionsstrom $I_S$,
   (c) Einstellen der Stärke des elektrischen Extraktionsfelds, um den Emissionsstrom im Wesentlichen stabil und kontinuierlich über dem mittleren stabilen Emissionsstrom $I_S$ bei einem vordefinierten Wert $I_C$ zu halten, der höher ist als $I_S$,
   (d) Durchführen eines Reinigungsprozesses, indem mindestens ein Heizimpuls auf den Kaltfeldemitter angewendet wird, um die Emitter-Oberfläche (5) auf eine Temperatur $T_C$ zu heizen, wobei der Reinigungsprozess durchgeführt wird, wenn die Stärke des elektrischen Extraktionsfelds einen vordefinierten Referenzwert überschreitet, und
   (e) Wiederholen des Einstellschritts (c) und des Reinigungsprozesses (d), um den Emissionsstrom des Kaltfeldemitters kontinuierlich über dem im Wesentlichen stabilen Emissionswert $I_S$ zu halten.

10. Verfahren nach Anspruch 9, wobei der vordefinierte Wert $I_C$ als $I_C = \alpha\,I_0$ definiert ist, wobei $\alpha > 0,9$ und insbesondere $\alpha > 0,95$ ist.

11. Verfahren nach einem der vorhergehenden Ansprüche, wobei es sich bei $T_C$ um ca. 2200 K bis 2500 K handelt.

12. Verfahren nach einem der vorhergehenden Ansprüche, wobei es sich bei der Impulsweite des mindestens einen Heizimpulses um 1 Sek. bis 2 Sek. handelt.

13. Verfahren nach einem der vorhergehenden Ansprüche, wobei jeder Reinigungsprozess ca. 10 Heizimpulse und insbesondere 2 bis 4 Heizimpulse umfasst, die an die Teilchenstrahlquelle oder den Kaltfeldemitter ca. alle 1 Sek. bis 3 Sek. angelegt werden.

14. Verfahren nach einem der Ansprüche 6 bis 12, wobei die Elektronenstrahlemissionsvorrichtung eine Suppressorelektrode (8) aufweist, die um den Emitter oder Kaltfeldemitter herum angeordnet ist, und wobei während des Reinigungsprozesses eine Suppressorspannung an die Suppressorelektrode (8) angelegt wird.

15. Verfahren nach Anspruch 14, wobei die Suppressorspannung zwischen 300 V und 1000 V beträgt.

16. Verfahren nach einem der vorhergehenden Ansprüche, wobei der Schritt (a) einen Hauptreinigungsprozess umfasst, um die Emitter-Oberfläche (5) so zu reinigen, dass die Quelle des Strahls geladener Teilchen oder der Kaltfeldemitter den hohen Anfangsemissionsstrom $I_0$ und den niedrigeren, stabilen mittleren Emissionsstrom $I_S$ aufweist.

17. Verfahren nach Anspruch 16, wobei der Hauptreinigungsprozess mindestens einen Haupthitzeimpuls umfasst, um die Emitter-Oberfläche auf eine Temperatur $T_{MC}$ zu heizen.

18. Verfahren nach Anspruch 16 oder 17, wobei es sich bei $T_{MC}$ um ca. 2500 K bis 2800 K handelt.

19. Verfahren nach einem der vorhergehenden Ansprüche, wobei die Quelle des Strahls geladener Teilchen oder der Kaltfeldemitter eine Emitter-Spitze hat, an der die Emitter-Oberfläche ausgebildet ist, und wobei ein thermischer Aufbauprozess (f) durchgeführt wird, um die Emitter-Spitze zu schärfen.

20. Verfahren nach Anspruch 19, wobei mehrere Heizimpulse auf die Quelle des Strahls geladener Teilchen oder auf den Kaltfeldemitter (2, 60) während des Aufbauprozesses (f) angewendet werden.

21. Verfahren nach Anspruch 20, wobei die Heizimpulse die Emitter-Oberfläche auf eine Temperatur $T_B$ heizen, die höher ist als die Temperatur $T_C$ des Reinigungsprozesses.

22. Verfahren nach einem der vorhergehenden Ansprüche, wobei der Reinigungsprozess automatisch mit betriebsfreien Perioden der Emissionsvorrichtung des Strahls geladener Teilchen oder der Elektronenstrahlemissionsvorrichtung synchronisiert wird.

23. Verfahren nach Anspruch 22, wobei es sich bei den betriebsfreien Perioden um Perioden handelt, während welcher der Strahl geladener Teilchen oder der Elektronenstrahl von einem Probestück oder einem Prüfstück defokussiert oder weggelenkt ist.

24. Verfahren nach Anspruch 22 oder 23, wobei die betriebsfreien Perioden durch einen Puls eines Zeitgebers, einen Abfall des Emissionsstroms, insbesondere wie in einem der Ansprüche 1 bis 21 definiert, einen Austausch eines Probestücks oder eines Prüfstücks, eine Kalibrierung der Emissionsvorrichtung des Strahls geladener Teilchen oder der Elektronenstrahlemissionsvorrichtung, eine Probestück- oder Prüfstückbewegung und/oder eine Probentischbewegung ausgelöst werden.

25. Emissionsvorrichtung eines Strahls geladener Teilchen, Folgendes aufweisend:

   eine Quelle (60) des Strahls geladener Teilchen, um geladene Teilchen zu emittieren, wobei die Quelle des Strahls geladener Teilchen eine Emitter-Oberfläche (5) aufweist,
   eine Spannungseinheit (86), um eine Spannung an die Quelle (60) des Strahls geladener Teilchen anzulegen, um einen Strahl (78) geladener Teilchen zu erzeugen,
   ein Heizelement (82), um die Emitter-Oberfläche (5) zu heizen,
   eine Steuereinheit (88), die einen Eingang (90) zum Empfangen eines Auslösesignals aufweist, wobei die Steuereinheit (88) operativ ist, das Heizelement (82) so zu steuern, dass es mindestens einen Heizimpuls auf die Emitter-Oberfläche (5) der Quelle (60) des Strahls geladener Teilchen während der Erzeugung des Strahls (78) geladener Teilchen auf den Empfang eines Auslösesignals hin anwendet,
   **dadurch gekennzeichnet, dass** die Emissionsvorrichtung des Strahls geladener Teilchen darüber hinaus ein Messelement (94), um den Emissionsstrom der Quelle (60) des Strahls geladener Teilchen zu messen, und eine Auslöseeinheit (98) aufweist, die dazu angepasst ist, das Auslösesignal bereitzustellen, wenn der Emissionsstrom auf einen vordefinierten Wert abgesunken ist.

26. Emissionsvorrichtung des Strahls geladener Teilchen nach Anspruch 25, wobei die Emissionsvorrichtung des Strahls geladener Teilchen einen Strahlaustaster (66) aufweist, wobei die Steuereinheit (88) funktionsfähig ist, den Strahlaustaster (66) so zu steuern, dass er den erzeugten Teilchenstrahl (78) auf einen Empfang des Auslösesignals hin ablenkt.

27. Emissionsvorrichtung des Strahls geladener Teilchen nach Anspruch 25, wobei die Emissionsvorrichtung des Strahls geladener Teilchen eine Fokussierungseinheit (92) aufweist, um den Strahl (78) geladener Teilchen auf ein Probestück oder ein Prüfstück (72) zu fokussieren und davon zu defokussieren, wobei die Steuereinheit (88) operativ ist, die Fokussierungseinheit (92) so zu steuern, dass sie den erzeugten Strahl (78) geladener Teilchen in Bezug auf

**EP 1 760 761 B1**

das Probestück oder das Prüfstück (72) auf einen Empfang des Auslösesignals hin defokussiert.

28. Emissionsvorrichtung des Strahls geladener Teilchen nach einem der Ansprüche 25 bis 27, wobei es sich bei der Emissionsvorrichtung des Strahls geladener Teilchen um eine Elektronenstrahlemissionsvorrichtung und bei der Quelle des Strahls geladener Teilchen um einen Elektronenemitter und insbesondere einen Kaltfeldelektronenemitter handelt.

29. Emissionsvorrichtung des Strahls geladener Teilchen nach Anspruch 28, wobei es sich bei der Elektronenstrahlemissionsvorrichtung um ein Rasterelektronenmikroskop (REM), ein Transmissions-Elektronenmikroskop (TEM) oder ein Raster-Transmissions-Elektronenmikroskop (RTEM) handelt.

30. Emissionsvorrichtung des Strahls geladener Teilchen nach einem der Ansprüche 25 bis 27, wobei es sich bei der Emissionsvorrichtung des Strahls geladener Teilchen um eine Ionenstrahlemissionsvorrichtung und bei der Quelle des Strahls geladener Teilchen um einen Ionenemitter handelt.

31. Emissionsvorrichtung des Strahls geladener Teilchen nach einem der Ansprüche 25 bis 30, wobei die Emitter-Oberfläche der Quelle (60) des Strahls geladener Teilchen einen Krümmungsradius von weniger als 250 nm hat.

32. Emissionsvorrichtung des Strahls geladener Teilchen nach einem der Ansprüche 25 bis 31, wobei die Emissionsvorrichtung des Strahls geladener Teilchen ein Trägerelement (96), um ein Prüfstück beweglich zu tragen, eine Bewegungssteuerungseinheit, um das Trägerelement (96) zu steuern, und eine Synchronisierungseinrichtung (98) aufweist, die dazu angepasst ist, ein Auslösesignal auf eine Bewegung des Trägerelements (96) hin bereitzustellen.

33. Emissionsvorrichtung des Strahls geladener Teilchen, Folgendes aufweisend:

eine Quelle (60) des Strahls geladener Teilchen, um geladene Teilchen zu emittieren, wobei die Quelle des Strahls geladener Teilchen eine Emitter-Oberfläche (5) hat,
eine Spannungseinheit (86), um eine vorbestimmte Spannung an die Quelle (60) des Strahls geladener Teilchen anzulegen, um einen Strahl (78) geladener Teilchen zu erzeugen,
ein Heizelement (82), um die Emitter-Oberfläche (5) aufzuheizen,
eine Steuereinheit (88), die einen Eingang (90) zum Empfangen eines Auslösesignals aufweist, wobei die Steuereinheit (88) operativ ist, das Heizelement (82) so zu steuern, dass es mindestens einen Heizimpuls auf die Emitter-Oberfläche (5) der Quelle (60) des Strahls geladener Teilchen während der Erzeugung des Strahls (78) geladener Teilchen auf den Empfang eines Auslösesignals hin anwendet,
**dadurch gekennzeichnet, dass** die Emissionsvorrichtung des Strahls geladener Teilchen darüber hinaus ein Messelement (94), um den Emissionsstrom der Quelle (60) des Strahls geladener Teilchen zu messen, und eine Auslöseeinheit (98) aufweist, die dazu angepasst ist, das Auslösesignal bereitzustellen, wenn die durch die Spannungseinheit (86) angelegte vorbestimmte Spannung einen vordefinierten Spannungswert ($U_{max}$) überschreitet.

## Revendications

1. Procédé de fonctionnement d'un dispositif émetteur de faisceau de particules chargées comprenant une source de faisceau de particules chargées (2, 60) présentant une surface d'émetteur (5), le procédé comprenant les étapes de :

(a) mise en place de la source de faisceau de particules chargées (2, 60) dans un vide d'une pression donnée, la source de faisceau de particules chargées (2, 60) fournissant un courant d'émission initial élevé $I_0$ et un courant d'émission moyen stable plus faible $I_S$ dans des conditions opératoires données,
(b) application des conditions opératoires données à la source de faisceau de particules chargées (2, 60) pour émettre des particules chargées depuis la surface d'émetteur (5), de sorte que le courant d'émission de la source de faisceau de particules chargées soit plus élevé que le courant d'émission moyen stable $I_S$,
(c) exécution d'un processus de nettoyage par application d'au moins une impulsion de chauffage à la source de faisceau de particules chargées afin de chauffer la surface d'émetteur (5) à une température $T_C$, sachant que le processus de nettoyage est exécuté avant que le courant d'émission de la source de faisceau de particules chargées ait décliné à la valeur d'émission moyenne stable plus faible $I_S$, et
(d) répétition du processus de nettoyage (c) pour maintenir le courant d'émission de la source de faisceau de particules chargées constamment au-dessus de la valeur d'émission sensiblement stable $I_S$.

**2.** Procédé tel que revendiqué dans la revendication 1, sachant que le processus de nettoyage (c) est exécuté à des intervalles de temps prédéfinis ou lorsque le courant d'émission a baissé à une valeur prédéfinie $I_C$, $I_C$ étant plus élevée que la valeur d'émission moyenne stable $I_S$.

**3.** Procédé tel que revendiqué dans la revendication 2, sachant que $I_C$ est définie comme $I_C = \alpha\ I_0$ avec $\alpha > 0,9$ et en particulier $\alpha > 0,95$.

**4.** Procédé tel que revendiqué dans l'une quelconque des revendications précédentes, sachant qu'une valeur maximum prédéfinie $I_{max}$ et une valeur minimum prédéfinie $I_{min} = I_C > I_S$ sont sélectionnées, sachant qu'une valeur d'écart moyenne $\Delta$ est définie comme $\Delta = I_{max} - I_{min}$, et le processus de nettoyage est exécuté lorsque le courant d'émission a chuté de la valeur d'émission maximum $I_{max}\ \Delta\ I_{min}$.

**5.** Procédé tel que revendiqué dans l'une quelconque des revendications précédentes, sachant que $\Delta I/I_{max} = \gamma$, et $\gamma$ est d'environ 0,1 et en particulier d'environ 0,05.

**6.** Procédé tel que revendiqué dans l'une quelconque des revendications précédentes, sachant que
le dispositif émetteur de faisceau de particules chargées est un dispositif émetteur de faisceau d'électrons,
la source de faisceau de particules chargées est un émetteur d'électrons destiné à émettre des électrons et
les conditions opératoires données comprennent une pression donnée et une énergie donnée appliquées à la surface d'émetteur de l'émetteur d'électrons pour extraire des électrons.

**7.** Procédé tel que revendiqué dans la revendication 6, sachant que l'émetteur d'électrons est un émetteur à champ froid et l'énergie est un champ électrique.

**8.** Procédé tel que revendiqué dans l'une quelconque des revendications précédentes, sachant que
le dispositif émetteur de faisceau de particules chargées est un dispositif émetteur de faisceau d'ions, et
la source de faisceau de particules chargées est un émetteur d'ions destiné à émettre des ions.

**9.** Procédé de fonctionnement d'un dispositif émetteur de faisceau d'électrons comprenant un émetteur à champ froid (2, 60) présentant une surface d'émetteur (5), le procédé comprenant les étapes de :

(a) mise en place de l'émetteur à champ froid (2, 60) dans un vide d'une pression donnée, l'émetteur à champ froid (2, 60) fournissant un courant d'émission initial élevé $I_0$ et un courant d'émission moyen stable plus faible $I_S$ dans un champ d'extraction électrique donné,
(b) application du champ d'extraction électrique donné à l'émetteur à champ froid (2, 60) pour émettre des électrons depuis la surface d'émetteur (5), de sorte que le courant d'émission de l'émetteur à champ froid soit plus élevé que le courant d'émission moyen stable $I_S$,
(c) réglage de l'intensité du champ d'extraction électrique pour maintenir le courant d'émission à un niveau sensiblement stable et constamment au-dessus du courant d'émission stable moyen $I_S$ à une valeur prédéfinie $I_C$ qui est plus élevée que $I_S$,
(d) exécution d'un processus de nettoyage par application d'au moins une impulsion de chauffage à l'émetteur à champ froid afin de chauffer la surface d'émetteur (5) à une température $T_C$, sachant que le processus de nettoyage est exécuté lorsque l'intensité du champ d'extraction électrique dépasse une valeur de référence prédéfinie, et
(e) répétition de l'étape de réglage (c) et du processus de nettoyage (d) pour maintenir le courant d'émission de l'émetteur à champ froid constamment au-dessus de la valeur d'émission sensiblement stable $I_S$.

**10.** Procédé tel que revendiqué dans la revendication 9, sachant que la valeur prédéfinie $I_C$ est définie comme $I_C = \alpha\ I_0$, sachant que $\alpha > 0,9$ et en particulier $\alpha > 0,95$.

**11.** Procédé tel que revendiqué dans l'une quelconque des revendications précédentes, sachant que $T_C$ est d'environ 2200 K à 2500 K.

**12.** Procédé tel que revendiqué dans l'une quelconque des revendications précédentes, sachant que la largeur d'impulsion de l'au moins une impulsion de chauffage est de 1 s à 2 s.

**13.** Procédé tel que revendiqué dans l'une quelconque des revendications précédentes, sachant que chaque processus de nettoyage comprend environ 10 impulsions de chauffage et, en particulier, 2 à 4 impulsions de chauffage étant appliquées à la source de faisceau de particules ou à l'émetteur à champ froid environ toutes les 1 s à 3 s.

14. Procédé tel que revendiqué dans l'une quelconque des revendications 6 à 12, sachant que le dispositif émetteur de faisceau d'électrons comprend une électrode suppresseuse (8) agencée autour de l'émetteur ou de l'émetteur à champ froid, et sachant qu'une tension suppresseuse est appliquée à l'électrode suppresseuse (8) pendant le processus de nettoyage.

15. Procédé tel que revendiqué dans la revendication 14, sachant que la tension suppresseuse est comprise entre 300 V et 1000 V.

16. Procédé tel que revendiqué dans l'une quelconque des revendications précédentes, sachant que l'étape (a) comprend un processus de nettoyage maître pour nettoyer la surface d'émetteur (5) de telle sorte que la source de faisceau de particules chargées ou l'émetteur à champ froid fournisse le courant d'émission initial élevé $I_0$ et le courant d'émission moyen stable plus faible $I_S$.

17. Procédé tel que revendiqué dans la revendication 16, sachant que le processus de nettoyage maître comprend au moins une impulsion de chauffage maître pour chauffer la surface d'émetteur à une température $T_{MC.}$

18. Procédé tel que revendiqué dans la revendication 16 ou 17, sachant que $T_{MC}$ est d'environ 2500 K à 2800 K.

19. Procédé tel que revendiqué dans l'une quelconque des revendications précédentes, sachant que la source de faisceau de particules chargées ou l'émetteur à champ froid comporte une pointe d'émetteur au niveau de laquelle la surface d'émetteur est formée et sachant qu'un processus de montée thermique (f) est exécuté pour affûter la pointe d'émetteur.

20. Procédé tel que revendiqué dans la revendication 19, sachant que de multiples impulsions de chauffage sont appliquées à la source de faisceau de particules chargées ou à l'émetteur à champ froid (2, 60) pendant le processus de montée (f).

21. Procédé tel que revendiqué dans la revendication 20, sachant que les impulsions de chauffage chauffent la surface d'émetteur à une température $T_B$, laquelle est plus élevée que la température $T_C$ du processus de nettoyage.

22. Procédé tel que revendiqué dans l'une quelconque des revendications précédentes, sachant que le processus de nettoyage est automatiquement synchronisé avec des périodes non opératoires du dispositif émetteur de faisceau de particules chargées ou du dispositif émetteur de faisceau d'électrons.

23. Procédé tel que revendiqué dans la revendication 22, sachant que les périodes non opératoires sont des périodes pendant lesquelles le faisceau de particules chargées ou le faisceau d'électrons est défocalisé ou dévié d'un échantillon ou spécimen.

24. Procédé tel que revendiqué dans la revendication 22 ou 23, sachant que les périodes non opératoires sont déclenchées par une impulsion d'un temporisateur, une baisse du courant d'émission, en particulier telle que définie dans l'une quelconque des revendications 1 à 21, un échange d'un échantillon ou spécimen, un calibrage du dispositif émetteur de faisceau de particules chargées ou du dispositif émetteur de faisceau d'électrons, un mouvement d'échantillon ou de spécimen et/ou un mouvement d'étage.

25. Dispositif émetteur de faisceau de particules chargées, comprenant :

une source de faisceau de particules chargées (60) pour émettre des particules chargées, la source de faisceau de particules chargées comprenant une surface d'émetteur (5),
une unité de tension (86) pour appliquer une tension à la source de faisceau de particules chargées (60) afin de générer un faisceau de particules chargées (78),
un élément chauffant (82) pour chauffer la surface d'émetteur (5),
une unité de commande (88) comprenant une entrée (90) pour recevoir un signal de déclenchement, l'unité de commande (88) étant opérationnelle pour commander l'élément chauffant (82) pour appliquer au moins une impulsion de chauffage à la surface d'émetteur (5) de la source de faisceau de particules chargées (60) pendant la génération du faisceau de particules chargées (78) lors de la réception d'un signal de déclenchement, **caractérisé en ce que** le dispositif émetteur de faisceau de particules chargées comprend en outre un élément de mesure (94) pour mesurer le courant d'émission de la source de faisceau de particules chargées (60), et une unité de déclenchement (98) apte à fournir le signal de déclenchement lorsque le courant d'émission a baissé à une valeur prédéfinie.

26. Dispositif émetteur de faisceau de particules chargées tel que revendiqué dans la revendication 25, sachant que le dispositif émetteur de faisceau de particules chargées comprend un suppresseur de faisceau (66), l'unité de commande (88) étant opérationnelle pour commander le suppresseur de faisceau (66) pour dévier le faisceau de particules (78) généré lors de la réception du signal de déclenchement.

27. Dispositif émetteur de faisceau de particules chargées tel que revendiqué dans la revendication 25, sachant que le dispositif émetteur de faisceau de particules chargées comprend une unité de focalisation (92) pour focaliser et défocaliser le faisceau de particules chargées (78) sur un échantillon ou spécimen (72), l'unité de commande (88) étant opérationnelle pour commander l'unité de focalisation (92) pour défocaliser le faisceau de particules chargées (78) généré par rapport à l'échantillon ou au spécimen (72) lors de la réception du signal de déclenchement.

28. Dispositif émetteur de faisceau de particules chargées tel que revendiqué dans l'une quelconque des revendications 25 à 27, sachant que le dispositif émetteur de faisceau de particules chargées est un dispositif émetteur de faisceau d'électrons et que la source de faisceau de particules chargées est un émetteur d'électrons et en particulier un émetteur d'électrons à champ froid.

29. Dispositif émetteur de faisceau de particules chargées tel que revendiqué dans la revendication 28, sachant que le dispositif émetteur de faisceau d'électrons est un microscope électronique à balayage (MEB), un microscope électronique par transmission (MET) ou un microscope électronique à balayage par transmission (MEBT).

30. Dispositif émetteur de faisceau de particules chargées tel que revendiqué dans l'une quelconque des revendications 25 à 27, sachant que le dispositif émetteur de faisceau de particules chargées est un dispositif émetteur de faisceau d'ions et la source de faisceau de particules chargées est un émetteur d'ions.

31. Dispositif émetteur de faisceau de particules chargées tel que revendiqué dans l'une quelconque des revendications 25 à 30, sachant que la surface d'émetteur de la source de faisceau de particules chargées (60) a un rayon de courbure de moins de 250 nm.

32. Dispositif émetteur de faisceau de particules chargées tel que revendiqué dans l'une quelconque des revendications 25 à 31, sachant que le dispositif émetteur de faisceau de particules chargées comprend un élément porteur (96) pour porter de manière mobile un spécimen, une unité de commande de mouvement pour commander l'élément porteur (96) et un moyen de synchronisation (98) apte à fournir un signal de déclenchement en cas de mouvement de l'élément porteur (96).

33. Dispositif émetteur de faisceau de particules chargées, comprenant :

une source de faisceau de particules chargées (60) pour émettre des particules chargées, la source de faisceau de particules chargées comprenant une surface d'émetteur (5),
une unité de tension (86) pour appliquer une tension prédéterminée à la source de faisceau de particules chargées (60) afin de générer un faisceau de particules chargées (78),
un élément chauffant (82) pour chauffer la surface d'émetteur (5),
une unité de commande (88) comprenant une entrée (90) pour recevoir un signal de déclenchement, l'unité de commande (88) étant opérationnelle pour commander l'élément chauffant (82) pour appliquer au moins une impulsion de chauffage à la surface d'émetteur (5) de la source de faisceau de particules chargées (60) pendant la génération du faisceau de particules chargées (78) lors de la réception d'un signal de déclenchement,
**caractérisé en ce que** le dispositif émetteur de faisceau de particules chargées comprend en outre un élément de mesure (94) pour mesurer le courant d'émission de la source de faisceau de particules chargées (60), et une unité de déclenchement (98) apte à fournir le signal de déclenchement lorsque la tension prédéterminée appliquée par l'unité de tension (86) dépasse une valeur de tension prédéfinie (Umax).

*Fig. 1*

*Fig. 2*

**Typical Heating Pulse**

HEATING CURRENT

TIME (t)

*Fig. 3*

EMISSION CURRENT (I)

$I_m$

$I_0$

a

$I_2$

$I_1$

O

$T_0$   $T_1$   $T_2$   $T_3$

TIME (T)

*Fig. 4*

Fig. 5

Fig. 6

```
                                              50
┌─────────────────────────────┐
│   Generating a particle beam │
└─────────────────────────────┘
              │
              │                               52
┌─────────────────────────────┐
│   Focusing particle beam on  │
│   a sample or specimen surface│
└─────────────────────────────┘
              │
         ╱────────────╲              54
   No   ╱               ╲
 ◄──── ◄  Triggering event ? ►
         ╲               ╱
          ╲─────────────╱
              │ Yes
              │                               56
┌─────────────────────────────┐
│   Defocusing or deflecting   │
│       particle beam          │
└─────────────────────────────┘
              │
              │                               58
┌─────────────────────────────┐
│  Performing a cleaning process│
└─────────────────────────────┘
```

*Fig. 7*

Fig. 8

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- US 4090106 A, Okumura
- US 5491375 A, Iwasaki
- US 20040124365 A
- US 3786268 A
- US 3825839 A
- US 3887839 A
- WO 2005027175 A
- US 3817592 A
- US 3947716 A, Frazer, Jr.

### Non-patent literature cited in the description

- **W. K. LO et al.** Titanium nitride coated tungsten cold field emission sources. *J. Vac. Sci. Technol.,* November 1996, vol. 14 (6), 3787-3791